(19) Europäisches Patentamt / European Patent Office / Office européen des brevets

(11) **EP 3 908 686 B1**

(12) **EUROPEAN PATENT SPECIFICATION**

(45) Date of publication and mention
of the grant of the patent:
**24.07.2024 Bulletin 2024/30**

(21) Application number: **20700111.6**

(22) Date of filing: **08.01.2020**

(51) International Patent Classification (IPC):
*C30B 33/00* (2006.01)   *C30B 35/00* (2006.01)
*G01B 11/30* (2006.01)   *G01B 11/08* (2006.01)
*G01B 11/02* (2006.01)   *G01B 11/24* (2006.01)
*C30B 29/06* (2006.01)

(52) Cooperative Patent Classification (CPC):
**C30B 33/00; C30B 29/06; C30B 35/00;
G01B 11/026; G01B 11/08; G01B 11/24;
G01B 11/30**

(86) International application number:
**PCT/EP2020/050278**

(87) International publication number:
**WO 2020/144212 (16.07.2020 Gazette 2020/29)**

(54) **A MARKING SCANNER**

MARKIERENDER SCANNER

SCANNER DE MARQUAGE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **08.01.2019 EP 19150810**

(43) Date of publication of application:
**17.11.2021 Bulletin 2021/46**

(73) Proprietor: **Topsil GlobalWafers A/S
3600 Frederikssund (DK)**

(72) Inventor: **MADSEN, Morten Hannibal
3500 Værløse (DK)**

(74) Representative: **AWA Denmark A/S
Strandgade 56
1401 Copenhagen K (DK)**

(56) References cited:
**EP-A2- 0 610 563      CN-A- 106 323 193
JP-A- H09 191 035      US-A1- 2017 052 024**

## Description

## Field of the invention

The present invention relates to a method of obtaining a surface characteristic parameter from a longitudinal marking of a single crystal ingot, and to a method of producing an orientation marked single crystal ingot. The methods provide single crystal ingots with improved tolerances. The invention also relates to an ingot scanner system for performing the method.

## Prior art

Single crystal materials have numerous applications, and in general, since the material is a single crystal material, the single crystal material also has a crystal orientation, and moreover, the crystal orientation may be important for the use of the single crystal material. For example, silicon wafers sliced from silicon single crystal ingots are used to produce microelectronic devices,, and a silicon single crystal ingot is typically provided in the {100} or {111} orientation although other orientations may also be relevant. As an example of how orientation markers are relevant in the field of semiconductors, EP 0610563 discloses a device and procedure for the combined determination of the crystal orientation of a semiconductor ingot and marking of the ingot with an orientation flat or notch.

Single crystals, e.g. single crystals of Si, GaAs, InAs, InP, or sapphire, can be fabricated using different methods, for example the Czochralski (CZ) process or the float-zone (FZ) method, which will both provide the single crystals in the form of single crystal ingots. Many single crystal materials are used in thin sheets or the like. For example, silicon single crystal ingots are typically sliced to wafers, e.g. with thicknesses up to about 1 mm.

In order to orient a wafer correctly, i.e. with respect to crystal orientation, for subsequent processing, the silicon single crystal ingot is typically provided with an orientation marking at a location based on the knowledge of the actual orientation of the silicon single crystal ingot. Thereby, all wafers sliced from the silicon single crystal ingot can have the orientation marker and be oriented correctly.

Silicon single crystal ingots, and other single crystal ingots, are normally prepared, e.g. in the CZ or FZ process, to be of a cylindrical shape with a generally round cross-section, and the silicon single crystal ingot is then ground to provide a smooth surface of a circular silicon single crystal ingot. The orientation marker will then be carved into the smooth surface, typically along the full length of the silicon single crystal ingot.

The orientation markers for silicon single crystal ingot have traditionally been "flats", "notches" or combinations of flats and notches. A flat has the shape of a secant in the circular cross-section, and a notch may be shaped like the letters "V" or "U" in the surface of the single ingot. A "U" notch may also be termed a circular notch and have a circular shape. For large single crystal ingots, e.g. of 150 mm diameter or more, notches are typically preferred since a flat can remove too much material from the single crystal ingot.

The actual shape of the orientation marker will normally not contain any specific information regarding the single crystal ingot. However, the single crystal ingot may have more than one orientation marker where additional information about the single crystal can be indicated by the multiple orientation markers. Typically, a major flat is used to identify the crystal orientation of the wafer. A minor flat, also referred to as a secondary flat, is typically used for identification of the dopant type, by placing it at a given angle from the major flat. In accordance to the SEMI standard, a minor flat positioned 45 degrees from the major flat indicates a {111} n-type crystal. However, this is only a guideline and flats defined differently from the SEMI standard are a possibility. A secondary flat can also be used to identify the front side and back side of a wafer.

For the end-customer the crystal orientation is important in the processing steps.

It is possible to measure the crystal orientation of the wafer directly, however, this is cumbersome and requires additional steps and equipment. It is easier to measure the crystal orientation on an ingot, e.g. using an X-ray goniometer, than on a single wafer. It is therefore an advantage for the end-customer to have a mark identifying the crystal orientation. The major flat can be used to align the wafer orientation in the processing steps, by placing the flat in a holder designed for the wafer, or using an alignment flat.

Notches can be used to mark the crystal orientation in the same way as flats. That is, instead of a flat, one can make a notch instead. It is beneficial to use notches as they cut away less material than a flat. The benefit is greater for larger crystals, as the material to be cut away when fabricating a flat increases, while it remains the same for notches. However, it is easier to align a wafer based on a flat than on notches. Typically, flats are used on ingots up to 6 inches, but it is an option to make them in even larger crystals. Notches are typically used for 6 inch crystals and larger. It is possible to place both flats and notches on the same ingot.

In the prior art, the measurement of the depth of a notch is commonly performed using a tactile device. The tactile measuring device includes a ball-head stylus that comes into contact with the test surface at the bottom of the notch, a beam to be placed on top of the hole, and a graduation scale for reading the measurement. The estimated measuring uncertainty is of the order 0.01 mm for such a device. However, the tactile measuring device suffers from a number of deficiencies. For example, there is a risk of false measurements from not probing the bottom of the notch due to the size of the ball-head probe. When the radius of curvature of the notch is smaller than the radius of curvature for the ball-head probe, it is not possible to measure the bottom of the notch. Furthermore, a contact probe measurement may scratch the surface and lead to degradation of the product. Also, measuring several notches requires several measurements. Thus, especially for ingots with multiple characteristics it is time-consuming to perform the measurements.

According to the prior art, the width of a notch is commonly recorded using a graduation scale, such as ruler combined with a magnifying glass. The graduation scale is placed on the surface of the notch, and a reading is performed at the start and end of the notch. The difference between the two readings is the width of the notch. The estimated measuring uncertainty is of the order 0.1 mm for such a device.

In the methods of the prior art, a graduation scale, such as a slide caliper or a ruler, can be used for measuring the width of the flats on a single crystal ingot. The graduation scale is placed on the surface of the flat, and a reading is performed at the start and end of the flat. The difference between the two readings is the width of the flats. This method is very sensitive to the operator performing the measurement, as the edge between curvature of the cylinder and the flat is estimated by eye. The estimated measuring uncertainty is of the order 0.1 mm for such a device.

For recording the angle between orientation markers in prior art methods a digital protractor can be used. However, the positioning of the protractor relies on the skills of the operator who should be very careful to find the centre of the surface marks.

For alignment of wafers without a flat, the notches can also be used for mechanical alignment of the wafer. By way of example, a wafer with two notches positioned 180 degrees from each other, is aligned by positioning one pin in each notch. The precision of the alignment depends on the precision and accuracy of the position and the geometrical shape of the notches. The shape of the pin should match the shape of the notches. An improved measurement method of the notches is therefore beneficial for the end customer to achieve an improved alignment of the wafer.

By way of example, calibration of the ingot scanner can be obtained by measuring certified gauge blocks. Both for the angle and depth measurement. With calibration of the instrument traceability can be established, which is important for the end-customer to ensure that a given specification is as described.

US 2017/052024 discloses an optical profiler for profiling an object of interest and a method for generating a profile image of the object of interest. The profiler and the corresponding method provide for the measurement of complicated test objects, such as camshafts, sliding cams and their helical cam groove, or even more complex shapes such as aircraft propellers. US 2017/052024 is not concerned with relating the profiling to specific non-visible details of the object.

CN 106323193 discloses a sapphire crystal ingot profile measuring device and a corresponding method. In the device, a laser emitter emits a laser beam, which is detected by a laser sensor. When a sapphire crystal is placed between the laser emitter and the laser sensor the laser beam is blocked by the sapphire crystal, and the width of the laser beam can be used to calculate the contour of the sapphire crystal. The device of CN 106323193 is limited to recording the profile of a convex crystal having a perimeter described with a continuous curve.

JPH09191035 discloses a method and a system for determining the shape of a notch in a silicon ingot.

In light of the importance of knowing the orientation of a single crystal material when using the single crystal material, there is a need for an improved method to relate the orientation marker on a single crystal material with the actual orientation of the single crystal material. The present invention aims to address this need.

**Disclosure of the invention**

The present invention relates to a method of obtaining a surface characteristic parameter of a longitudinal orientation marking of a single crystal ingot, the method comprising the steps of: providing a single crystal ingot having a cylindrical shape with a longitudinal centre axis and a radius from the longitudinal centre axis, the radius defining a surface of the single crystal ingot, the single crystal ingot having a longitudinal orientation marking carved into the surface of the single crystal ingot, the longitudinal orientation marking having a width; rotating the single crystal ingot around a rotational axis, the rotational axis being substantially parallel with the longitudinal centre axis and located within an offset value from the longitudinal centre axis; recording angular positions of the single crystal ingot; recording distances from a measuring point located at a measuring distance from the rotational axis to the surface of the single crystal ingot at the angular positions; providing a data array containing the angular positions and the distances at the corresponding angular positions; calculating a background shape for the single crystal ingot from the data array; comparing the distances with the background shape to identify distances deviating from the background shape; registering the angular position of distances deviating from the background shape and the corresponding distances; and simultaneously defining the surface characteristic parameter and the width from consecutive angular positions having distances deviating from the background shape and the corresponding distances.

In another aspect, the invention relates to a method of producing an orientation marked single crystal ingot, the method comprising the steps of: providing a single crystal ingot having a cylindrical shape with a longitudinal centre axis and a radius from the longitudinal centre axis, the radius defining a surface of the single crystal ingot; determining a crystal orientation for the single crystal ingot; carving a longitudinal orientation marking based on the crystal orientation into the surface of the single crystal ingot to provide an orientation marked single crystal, the longitudinal marking having a width; obtaining a surface characteristic parameter of the orientation marked single crystal ingot in the steps of: rotating the orientation marked single crystal ingot around a rotational axis, the rotational axis being substantially parallel with the longitudinal centre axis and located within an offset value from the longitudinal centre axis; recording angular positions of the orientation marked single crystal ingot; recording distances from a measuring point located at a measuring distance from the rotational axis to the surface of the orientation marked single crystal ingot at the angular positions; providing a data array containing the angular positions and the distances at the corresponding angular positions; calculating a background shape for the orientation marked single crystal ingot from the data array; comparing the distances with the background shape to identify distances deviating from the background shape; registering the angular position of distances deviating from the background shape and the corresponding distances; and simultaneously defining the surface characteristic parameter and the width from consecutive angular positions having distances deviating from the background shape and the corresponding distances; and labelling the orientation marked single crystal ingot with the surface characteristic parameter. The method may optionally comprise the step of grinding the surface of the single crystal ingot to provide the single crystal ingot with a substantially circular cross-section in the radial dimension.

In a further aspect, the invention relates to an ingot scanner system comprising a rotational device for rotating a single crystal ingot, the rotational device having a rotational axis; a light source for emitting a light toward the rotational axis, the light source being located at a measuring point at a measuring distance from the rotational axis; a light detector for registering light reflected and/or scattered from a surface of a single crystal ingot on the rotational device; a data storage unit for storing a data array containing angular positions of the single crystal ingot and light registered by the light detector at the angular positions; and a data processing unit configured to calculate distances from the measuring point to the surface of the single crystal ingot from the data array, the data processing unit further being configured to calculate a background shape for the single crystal ingot from calculated distances and to identify distances deviating from the background shape. The ingot scanner system is configured to obtain a surface characteristic parameter of a longitudinal marking carved into the surface of a single crystal ingot having the longitudinal marking in the steps of:

rotating the single crystal ingot around the rotational axis, the rotational axis being substantially parallel with the longitudinal centre axis of the single crystal ingot and located within an offset value from a longitudinal centre axis of the single crystal ingot; recording angular positions of the single crystal ingot; recording distances from a measuring point located at a measuring distance from the rotational axis to the surface of the single crystal ingot at the angular positions; providing a data array containing the angular positions and the distances at the corresponding angular positions; calculating a background shape for the single crystal ingot from the data array; comparing the distances with the background shape to identify distances deviating from the background shape; registering the angular position of distances deviating from the background shape and the corresponding distances; and simultaneously defining the surface characteristic parameter from consecutive angular positions having distances deviating from the background shape and the corresponding distances.

In general, all embodiments of the method of the first aspect can be used in the method of the second aspect, and any advantage obtained in the first method for features also available to the method of the second aspect is equally relevant in the second aspect. Likewise, the ingot scanner system of the invention may be used in any embodiment of the method aspects. The steps in the methods may employ various devices, apparatuses etc. and any such device or apparatus is relevant for the ingot scanner system of the invention, and any advantage described in the context of a device or apparatus is also relevant for the ingot scanner system of the invention.

In the first aspect, the method of the invention obtains a surface characteristic parameter of a longitudinal orientation marking of a single crystal ingot. Longitudinal orientation markings may be used to indicate information about the single crystal ingot, and therefore the longitudinal orientation marking of relevance will have been applied to the surface of the single crystal ingot based on the crystal orientation of the single crystal ingot. The "surface characteristic parameter" may be any parameter relevant for any longitudinal marking. The longitudinal orientation marking has at least a width, which is obtained in the method together with the surface characteristic parameter. The width may also be considered a surface characteristic parameter in the context of the invention. In the context of the invention, the "width" is defined in a plane normal to the longitudinal centre axis. Certain longitudinal markings will also have a depth, and parameters related to the shape of the longitudinal marking. For example, the longitudinal marking may be a notch, and for a notch the surface characteristic parameter may be width, depth, and radius of curvature, and/or roundness, e.g. for U shaped notches ("U-notches"), or the surface characteristic parameter may be width, depth, and sidewall angles, e.g. for V shaped notches ("V-notches"). The longitudinal marking may also be a flat. A flat has the shape of a secant in the plane normal to the longitudinal centre axis, e.g. the circular cross-section of a silicon single crystal ingot, so that the flat has a width defined in the plane normal to the longitudinal centre axis. The surface characteristic parameter of a flat may be that it is a flat, e.g. that it does not have a depth and/or that it is not a notch. For example, the surface characteristic parameter can differentiate a notch from a flat. The single crystal ingot may have more than one longitudinal marking, and in this case the surface characteristic parameter may also include an angle between two longitudinal markings or the distance between the longitudinal markings, e.g. the distance between the bottom of one notch to the bottom of another notch.

In general, a single crystal ingot will have a longitudinal marking indicating the crystal orientation of the single crystal ingot. A longitudinal marking indicating the crystal orientation of the single crystal ingot may also be referred to as the first longitudinal marking or as a "longitudinal orientation marking". The surface characteristic parameter for a longitudinal marking does not depend on whether the longitudinal marking is a longitudinal orientation marking, and when the present application mentions a "longitudinal marking" the term may be replaced with "longitudinal orientation marking", and vice versa.

The method of the invention advantageously allows that multiple surface characteristic parameters, e.g. the width and a further surface characteristic parameter, can be measured simultaneously. In particular, since the longitudinal marking is an orientation marking, better information about the orientation marking, e.g. on a single crystal ingot produced according to the invention, in relation to its actual orientation is obtained compared to the methods of the prior art. Thereby, the methods provide improved tolerances and lower rejection rates of single crystal ingots are obtained for the end-user when crystal orientation is important. By way of example, both the depth and the width of a notch is measured at the same time with the invention. With prior art instruments, this would have required two measurements, one for measuring the depth and one for measuring the width. Likewise, the width of a flat can be analysed and at the same time it can be determined if the flat is a major flat or a minor flat, and other details of relevance will be revealed at the simultaneous analysis.

Being a single crystal, the single crystal ingot has an orientation, i.e. a crystal orientation, which is important for the subsequent use of the single crystal material. Any single crystal having an orientation is relevant for the invention. For example, the single crystal ingot may be a silicon single crystal. The length of the single crystal ingot may be chosen freely, and for e.g. silicon single crystals the length will typically be up to 200 cm. The silicon crystal ingots may be cut to shorter lengths before analysing in the method of the invention, and 4" crystal ingots will typically have a length of up to 40 cm, and 8" crystal ingots will typically have a length of up to 30 cm. In the context of the invention, the size of a single crystal ingot, especially a silicon single crystal ingot, may be indicated in inches (") or mm; in general, 4" correspond to 100 mm, 6" correspond to 150 mm, 8" correspond to 200 mm, etc. and the two values may be used interchangeably. Silicon single crystals are sliced into wafers, e.g. with thicknesses of 1 mm or less, and the knowledge of the crystal orientation will be relevant for all wafers, and therefore a silicon single crystal ingot will normally have the orientation marking along its full length.

Single crystal ingots, in particular silicon single crystal ingots, may have more than one longitudinal marking. When a single crystal ingot has two or more longitudinal markings, the method of obtaining the surface characteristic parameter according to the invention is especially advantageous since the information obtained, e.g. the surface characteristic parameters of the two or more longitudinal markings, is linked. For example, the surface characteristic parameter of a first longitudinal marking is linked to the surface characteristic parameter of a second longitudinal marking, and both surface characteristic parameters are linked to the background shape. Thereby, a better description of a single crystal ingot with two or more longitudinal markings is available than when the longitudinal markings are analysed using other techniques.

The single crystal ingot has a longitudinal marking in the surface of the single crystal ingot. In the context of the invention, the term "in the surface" means that the longitudinal marking is carved into the surface of the single crystal ingot.

Distances from the measuring point to the surface of the single crystal ingot are recorded in the methods of the invention. In the context of the invention, a "distance" may be represented as a single point, or the distance may be represented as a matrix of several points. For example, the distance for an angle position, e.g. an angle indicated as a single value, may be indicated as a two-dimensional matrix, a one-dimensional matrix, i.e. a "line", or as a single point. The data of a line or a matrix will typically correspond to a single angular position although the data in the line or matrix will represent a section of the surface, e.g. several mm or cm, so that when lines or matrices are used the same point in the surface of the single crystal ingot may be better described than when single points are used. For example, the methods or the system may employ a laser scanner emitting light in an angle from an emission point, the laser scanner detecting light in a line or a matrix. When the distance is indicated as a line, the line will typically be in a lateral plane of the single crystal ingot. The distances from the measuring point to the surface of the single crystal ingot at the angular positions are recorded in the methods of the invention. The distance between the measuring point and the surface of the single crystal ingot may be obtained using any method as desired. It is also possible to employ more than one measuring point, and the distance to the surface of the single crystal ingot may be recorded for each measuring point. Likewise, the data obtained may be recorded using any method and appropriate device as desired. In the context of the invention, obtaining and recording distances for the angular positions may also be referred to as a "scan" and the in the methods the surface of the single crystal ingot is thus "scanned". Correspondingly, the apparatus for obtaining distances may be referred to as a "scanner". The data will typically be digital. In general, the scanner may store the data, or the data may be transferred to a computer or the like. Data transfer may be via any protocol, e.g. via a cable or wireless connection.

In a preferred embodiment the ingot scanner system is also used to characterise the roughness of the single crystal ingot, and likewise the method may characterise the roughness of the single crystal ingot. Roughness is a surface parameter describing how much the surface deviates from a perfect surface. The roughness can be measured using either line scans for the roughness in the lateral direction, or by moving the scanner using the vertical stage for roughness in the axial direction.

In a preferred embodiment, a light is applied towards the rotational axis, and reflected and/or scattered light from the surface of the single crystal ingot, e.g. the rotating single crystal ingot, are recorded and used to calculate the distance. The light source may be located at an emission point, which may be the same as the measuring point or different from the measuring point. When the emission point is different from the measuring point, the distance from the emission point to the rotational axis may be referred to as the emission distance. The emission distance may be the same as or different from the measuring distance. The distance from the measuring point and/or the emission point to the surface of the single crystal ingot will typically be in the range of 10 mm to 100 mm. The distance from the measuring point and/or the emission point to the surface of the single crystal ingot may depend on the scanner technology employed. When the distance is measured using light, the scanner may be referred to as an "optical scanner". Any light source may be used, but it is preferred that the light has a narrow distribution of wavelengths, e.g. that the light is monochromatic. The light source may also be referred to as a light emitter. In a specific embodiment, the light is a laser light, e.g. a laser diode. Correspondingly, the reflected light and/or the scattered light may be recorded using any method and device as desired. For example, the reflection and/or the scattering may be recorded using any detector. A laser light source and a detector for the laser light, i.e. the reflected laser light, may collectively be referred to as a "laser scanner". When the methods employ light for recording the distance, any additional optical element may be used. Appropriate optical elements include lenses, gratings, and mirrors. In another embodiment, the distance from the measuring point to the surface of the single crystal ingot involves tactile measurements of the distance. Regardless of the method of measuring the distance, the distance to be included in the data array should be the distance in the direction from the measuring point toward the rotational axis.

The single crystal ingot has a cylindrical shape with a longitudinal centre axis and a radius from the longitudinal centre axis. It is to be understood that the single crystal ingot is not limited to having a circular cross-section but it may also have a cross-section deviating from a circular cross-section. The calculations employed in the methods provide that the actual shape of the cross-section, i.e. the cross-sectional shape of the single crystal ingot without the orientation marking, is determined as the background shape, and the calculations are valid for any cross-section for which the perimeter can be described with a continuous curve. In the context of the invention, the term "continuous" means that the curve may be described with a single mathematical function. A continuous perimeter may also be described as "smooth" and the two terms may be used interchangeably. The cross-sectional shape of the single crystal ingot is typically convex. In the context of the invention, the term "convex" means that a straight line between any two points within the background shape does not cross the surface of the background shape. The longitudinal orientation marking, e.g. a notch, may represent a shape deviating from the convex shape of the background shape, but the longitudinal orientation marking will deviate from the continuous curve of the perimeter of a convex background shape. Thus, deviations from the background shape can be identified for any perimeter describable as a continuous curve. For example, the single crystal ingot may have an oval cross-section, or a cross-section that can be described as an ellipsis, and a single crystal ingot having an oval or elliptical cross-section may also be treated in the methods of the invention to obtain the surface characteristic parameter.

The background shape, in particular the diameter of a circular single crystal ingot, is determined in the method of the invention. In prior art methods, the diameter of a circular single crystal ingot will commonly be recorded using a micrometer screw gauge. However, the measurements are very sensitive to the skills of the operator operating the equipment. If not placed on the widest point of the circumference, a too small diameter is measured. The measurements are sensitive to the force used to tighten the screw. In contrast, for the method of the invention the measuring uncertainty is down to 0.01 mm, and with no risk of false measurements. Thus, when the single crystal ingot has a substantially circular cross-section in the radial dimension, the uncertainty of the determination of the diameter of the single crystal ingot is reduced compared to recording the diameter using prior art methods. Moreover, the method of the invention will also provide information on deviations from a circular cross-section.

The longitudinal central axis is located at the centre of mass of a plane normal to the longitudinal centre axis. For a single crystal ingot with a circular cross-section the centre of mass is the point which is equidistant to the surface of the single crystal ingot in the plane normal to the longitudinal centre axis.

The single crystal ingot is rotated around a rotational axis that is substantially parallel with the longitudinal centre axis and located within an offset value from the longitudinal centre axis. The closer the rotational axis is to the longitudinal centre axis, the simpler the calculations to determine the background shape, and furthermore the lower the uncertainty of the determination of the distances from the measuring point to the surface of the single crystal ingot. In particular, the lower the offset value, the lower the uncertainty of the distances determined to deviate from the background shape. Thus, the lower the offset value the better the description of the single crystal ingot and its orientation marking and the corresponding surface characteristic parameter. It is preferred that the offset value is 5 mm or less, e.g. 2 mm or less, e.g. 0.5 mm or less.

The method of obtaining a surface characteristic parameter involves recording angular positions of the single crystal ingot and recording distances from a measuring point located at a measuring distance from the rotational axis to the surface of the single crystal ingot at the angular positions. The measuring point is at a constant position compared to the rotating single crystal ingot, so that the recorded distances will describe the surface of the rotating single crystal ingot. Thereby, a data array containing the angular positions and the distances at the corresponding angular positions is obtained for the single crystal ingot. Thus, when the single crystal ingot has rotated 360° the full surface of a plane of the single crystal ingot will be contained in the data array. The data in the data array are used to calculate the background shape for the single crystal ingot. The data array will thus provide knowledge about the cross-section of the single crystal ingot. The background shape may be included in the data array. For example, the data array may contain information on the cross-sectional shape, e.g. circular, elliptical, etc., and parameters defining the corresponding cross-sectional shape, e.g. diameter, minor and major axes etc.

The data array obtained from a 360° rotation of the single crystal ingot will contain information allowing the background shape to be determined and consequently also to identify data points deviating from the background shape. The background shape corresponds to the cross-sectional shape of the single crystal ingot without the orientation marking and therefore the cross-sectional shape will be determined from consecutive groups of distances, i.e. distances of consecutive angular positions, corresponding to a specific background shape. Likewise, consecutive groups of distances deviating from the specific background shape will represent the orientation marking. Distances deviating from the background shape can generally be discarded as outliers if they cannot be grouped with other deviating distances in a series of consecutive angular positions. Once the data points have been classified as "background" or "marking" the data points in the data array of the corresponding angular positions will be labelled accordingly.

Once the background shape has been determined, e.g. when the single crystal ingot has been rotated 360° in the method of the invention, the offset value may be determined. Thus, the calculations of the background shape will also determine the offset value. By determining the offset value, the method of the invention will provide information on the uncertainty of the surface characteristic parameter obtained in the method. The offset value will typically be included in the data array for a single crystal ingot.

The calculations of the background shape and the accompanying offset value provide information for the operator about how to relocate the single crystal ingot in order to minimise the offset value. In a specific embodiment, the method comprises the step of relocating the single crystal ingot to minimise the offset value. Once the offset value has been minimised, the method should be repeated with the single crystal ingot now located at a position with a lower offset value. After relocating the single crystal ingot the method can thus be started over to provide an improved data array at the lower offset value and a corresponding lower uncertainty for the surface characteristic parameter. By relocating the single crystal ingot to minimise the offset value and repeating or continuing the method, the uncertainty of the surface characteristic parameter will be improved so that the value of the single crystal ingot, and thereby also of sections, e.g. wafers from a silicon single crystal ingot, will be improved to the end-user of the section of the single crystal ingot.

The background shape may be determined based on knowledge of the general shape of the single crystal ingot. For example, the operator will recognise, prior to performing the method, that the single crystal ingot for analysis has a cross-section with a circular or elliptical shape etc., and this information may be used to aid in the determination of the background shape. With a prior indication of the general shape of the single crystal ingot the background shape can be determined faster than without this information. In particular, when the data array is obtained with prior knowledge of the general background shape, the actual background shape can be determined by analysing a smaller section of the single crystal ingot, e.g. 180° of the single crystal ingot.

The method may record distances for any number of angular position, in particular for any number of angular position distributed within a 360° rotation. In an embodiment, the single crystal ingot is rotated 360°, and distances are recorded for angular positions spaced at angles in the range of 0.06° to 36°. The angles between angular positions may be the same or different over a 360° rotation. In the context of the invention, angular positions spaced at angles in the range of 0.06° to 36° are referred to as a "low resolution scan". For example, the data array for a low resolution scan may contain data for up to 6000 angular positions. A low resolution scan, e.g. over a 360° rotation, is sufficient to determine the background shape. In a specific embodiment, the background shape is determined in an initial low resolution scan, which may be followed by a scan at a higher resolution.

The single crystal ingot may be rotated using any method as desired. In the context of the invention it is to be understood that the single crystal ingot and the equipment for recording distances, e.g. the scanner, are moved relative to each other around the rotational axis. Thus, either the single crystal ingot may be rotated or the scanner may be rotated but in both cases the rotation will be around the rotational axis. The rate of rotation of the single crystal ingot may be chosen freely. For example, the single crystal ingot may be rotated at a rate in the range of 0.06°/s to 72°/s, such as 1°/s, 2°/s, 4°/s, 10°/s or 20°/s, 50°/s, e.g. about 6°/s for a 150 mm diameter silicon single crystal ingot. In general, for larger single crystal ingots, such as single crystal ingots of 150 mm or 200 mm diameter, slower rotation speeds are preferable and for smaller ingots, such as single crystal ingots of 100 mm diameter or less, faster rotation speeds are preferable. The rotational direction may be clockwise or counter clockwise. It is also possible for the methods to employ a combination of clockwise or counter clockwise rotation. For example, the single crystal ingot may be rotated clockwise over a certain angle, and the rotational direction may then be reversed to counter clockwise. Data points may be recorded in either rotational direction or both rotational directions. Any rotational device, e.g. a rotary stage, may be used in the method. The rotational device may be rotated using any method as desired. In a preferred embodiment the rotational device is a rotary stage having a stepper motor. A stepper motor will lower the uncertainty of the angular position compared to other drives and thereby correspondingly improve the determination of the surface characteristic parameter for a single crystal ingot analysed in the method. In a preferred embodiment the rotary stage is equipped with an encoder for higher precision of the angular values compared to a motor without an encoder.

In an embodiment, the method further comprises the step of moving the measuring point in a longitudinal direction relative to the single crystal ingot. Thus, the scanner and/or the single crystal ingot may be moved. For example, the ingot scanner system may comprise a device for lifting the single crystal ingot, or an elevating device may lift and/or lower the scanner. By moving the measuring point relative to the single crystal ingot it is possible to expand the surface characteristic parameter to also include information in the longitudinal direction of the single crystal ingot. For example, the surface characteristic parameter may thus include information about the longitudinal marking at several positions along the length of the single crystal ingot, which can be included in the same data array thereby providing further knowledge to the end-user and improved tolerances compared to analysing the longitudinal marking at single locations. For example, by moving the scanner and/or the single crystal ingot longitudinally relative to each other it is possible to determine if the longitudinal marking deviates from the longitudinal centre axis of the single crystal ingot or if the longitudinal marking deviates over the length of the longitudinal marking.

In a specific embodiment, the lifting device may also move the scanner in a lateral plane relative to the single crystal ingot. Thereby, the measuring distance can be varied so that the same surface characteristic parameter can be analysed at different setting of the scanner to further improve the data. The device for lifting the single crystal ingot may also move the single crystal ingot in a lateral plane, e.g. to recentre the single crystal ingot in order to lower the offset value.

In general, the recorded distances are added to the data array as the data array is being recorded so that the method may indicate when sufficient data has been obtained to determine the background shape. For example, when the method is performed with prior knowledge of the general background shape the background shape may be obtained after rotating the single crystal ingot 180°. By continuing the rotation beyond 360° while obtaining data, the determination of the background shape can be improved by recording several data points for the same angular position.

Once the background shape has been determined, consecutive groups of distances deviating from the specific background shape will indicate the angular position of the longitudinal marking. In general, the methods of the invention determine the background shape in an initial scan, e.g. by using a low resolution scan over 360° or a section of the single crystal ingot. The angular position(s) of the longitudinal marking(s) will be found in the initial scan. At any time, the rotational direction may be reversed and the single crystal ingot rotated so as to allow the scanner to (re)analyse the surface of the single crystal ingot at an angular position identified as a longitudinal marking. Thus, the methods of the invention may further comprise the step of reanalysing the consecutive angular positions of the surface characteristic parameter at a higher resolution after identifying the consecutive angular positions. The reanalysis may be done using the same scanner as in the first analysis or using a different scanner. Once the consecutive angular positions of the surface characteristic parameter have been identified the reanalysis will typically record distances for at least 5 angular positions, e.g. at least 10 angular positions, at least 50 angular positions or at least 100 angular positions, of the identified longitudinal marking. By initially calculating a background shape for the single crystal ingot and finding the locations of the longitudinal markings from the initial scan and then reanalysing the longitudinal marking to obtain the surface characteristic parameter, a much faster process is provided than by performing a full high resolution scan. Furthermore, the initial scan will provide additional information, e.g. regarding the relative position of one or more longitudinal markings, that will not be provided by analysing only the position of the longitudinal marking, e.g. by manually positioning the scanner and analysing the longitudinal marking. Thus, in particular the initial scan will be over 360° of the single crystal ingot.

In an embodiment, the surface of the single crystal ingot is analysed in the initial scan at a low resolution, and the angular positions corresponding to a longitudinal marking are subsequently rescanned, e.g. at a higher resolution. In particular, a longitudinal marking may be identified in a low resolution scan, and the scanner may be relocated to the identified angular position corresponding to the longitudinal marking. The longitudinal marking may then be scanned at a higher resolution. For example, the rotation of the single crystal ingot may be stopped at an angular position having a distance deviating from the background shape, and the distance from the measuring point to the surface of the single crystal ingot is recorded at the angular position without rotating the single crystal ingot. The scans at the low and high resolution may be performed using the same scanner, or a different scanner may be used for the high resolution scan than for the low resolution scan. When the method contains a high resolution scan, the high resolution scan is preferably obtained without rotating the single crystal ingot. By stopping the rotation and recording the high resolution scan the data quality, e.g. the resolution of the high resolution scan, will generally be improved compared to scanning performed while the single crystal ingot is rotating. In particular, the uncertainty of the angular position will be lower when the single crystal ingot is not rotating. In a preferred embodiment the acquisition time is fast relative to the rotation of the ingot, such that the disturbance from a moving sample is negligible. Thus, it is possible to obtain a high resolution scan without actually stopping the motion.

A preferred scanner, especially for performing high resolution scans, is a laser scanner having a laser source and an appropriate detector. A laser scanner will typically provide a laser light of a wavelength in the range of 400 nm to 700 nm, e.g. a 405 nm laser (a blue laser) or a 658 nm laser (a red laser), emitted at an aperture angle in the range of 5° to 30° towards the surface of the single crystal ingot. The distance from the emitter of the laser light, i.e. the emission point, to the surface of the single crystal ingot may depend on the specific laser scanner, e.g. as defined by the wavelength of the laser light and the aperture angle, but it will generally be in the range of 20 mm to 100 mm. Likewise, the distance from the surface of the single crystal ingot to the measuring point may also depend on the specific laser scanner. The laser scanner will have a detector, e.g. at the measuring point, for detecting laser light reflected and/or scattered from the surface of the single crystal ingot. The detector may record, e.g. record simultaneously, a number of points. The number of points may for example be in the range of 500 to 5000, e.g. 1000 to 2000 although other numbers outside these ranges are also possible. Thereby, the laser scanner may have a nominal lateral resolution in the range of 1 $\mu$m to 10 $\mu$m. In general, the shorter the wavelength, the better the resolution of the detector and thereby the laser scanner. Exemplary laser scanners are sold by Micro-Epsilon Messtechnik GmbH & Co. KG, Ortenburg, Germany, e.g. laser scanners marketed under the series name Models LLT 2900 (https://www.micro-epsilon.co.uk/2D 3D/laser-scanner/model-overview/?select=A LLT 2600-25). Laser scanners are well-known to the skilled person. The high resolution laser scanner can record a matrix of points simultaneously, such as a line array, or the high resolution laser scanner can record a single point at a time. Single points can be obtained by retracting a single value, taking the mean of multiple values, e.g. from 2 to 100 values, such as 10 values, or take the median of multiple values, e.g. from 2 to 100 values, such as 10 values. Recording of single points can be used in a low resolution scan in order to quickly identify the background shape, and the same laser scanner can then be used as a high resolution scanner to record matrices at locations indicated to represent the longitudinal marking.

A high resolution scan, especially a high resolution scan obtained when the single crystal ingot is not rotating, is especially useful for analysing a notch. A notch is generally more complex than a flat and more information is thus contained in a notch compared to a flat. For example, a flat will mainly be described by its position in the single crystal ingot and its width. In the method of the invention the flat will be detected from a "start point" relative to the rotation so that an angular position will correspond to the starting point, and likewise the flat will have an "end point" that will also be detected upon rotation of the single crystal ingot, and the end point will have a corresponding angular position. The width of a major flat will typically be up to 70 mm for a 150 mm single crystal ingot, but for smaller single crystal ingots the width of a major flat will normally be smaller, e.g. in the range of 50 mm to 60 mm or less, e.g. about 25 mm to 35 mm for a 4" single crystal ingot. The method of the invention allows that smaller flats are used due to the improved description of the surface characteristic parameter compared to prior art methods, and thereby the methods of the invention provide that less material needs to be removed from a single crystal ingot.

In contrast, a notch will, in addition to a start point and an end point, and the corresponding width, also have a shape and a depth. Due to the smaller dimensions of a notch compared to a flat accurate determination of the notch using prior art methods is more difficult than determining the position of a flat, and moreover, especially the shape but also the depth of the notch cannot be determined according to prior art methods with the same accuracy as available in the present method.

In an embodiment of the invention, the surface characteristic parameter includes details about the longitudinal marking. For a flat these details will normally comprise the start point and the end point, and thereby also a width of the flat, and a position of the flat relative to the crystal orientation of the single crystal ingot. For a notch the details will normally comprise the start point and the end point, and thereby also a width of the notch, and the position of the notch relative to the crystal orientation of the single crystal ingot, and for a notch the surface characteristic parameter may further include the shape, e.g. if the notch has a V shape or a U shape, its depth, and width. Specifically, for U shaped notches the radius and the roundness may be determined, and for V shaped notches the sidewall angles may be determined. Notches and flats are particularly relevant for silicon single crystal ingots. The width of a notch is typically in the range of 1 mm to 8 mm, e.g. 2 to 4 mm. The depth of a notch is typically in the range of 0.5 mm to 3 mm. For a typical silicon single crystal ingot, e.g. having a diameter of 150 mm, 200 mm, or 300 mm, the width of the notch compared to the circumference of the silicon single crystal ingot can also be represented as an angle. The "angle" of the notch will indicate the optimal resolution for obtaining the surface characteristic parameter of the notch. In a specific embodiment the longitudinal marking is a notch, and the background shape of the single crystal ingot is determined in a low resolution scan, where the location of the notch is determined. After identifying angular positions corresponding to distances deviating from the background shape and thus representing the notch, the angular positions of the notch are reanalysed by recording distances of at least 5 angular positions in the "angle" of the notch. The same approach may also be used for other longitudinal markings than notches, in particular longitudinal markings taking up only a small "angle" in the surface of the single crystal ingot, and likewise this approach is not limited to silicon single crystal ingots.

When the method of the invention uses a scanner measuring reflection/scattering from the surface of the single crystal ingot, e.g. a laser scanner, the measuring uncertainty for measuring the depth of a notch may be down to 0.005 mm compared to the measuring uncertainty in the order 0.01 mm of a ball-head stylus measurement of the prior art. Likewise, the method of the invention provides a much improved uncertainty for obtaining the width of a notch, so that when the width is obtained, e.g. using a laser scanner, the measuring uncertainty is down to 0.01 mm, compared to the uncertainty of 0.1 mm when using a graduation scale combined with a magnifying glass as done in the prior art. Furthermore, the prior art requires judgement by eye to determine that the recording is actually the diameter, but in the method of the invention this is not necessary. When a notch is applied to a single crystal ingot produced according to the method of the invention, as an example of a longitudinal marking, the width of the notch will typically have a predetermined value, e.g. 2.80 mm, which can be prepared in the method according to the invention with a tolerance of ±0.20 mm. The predetermined value of the width may be indicated as a surface characteristic parameter in the label for the single crystal ingot, and the actual width of the notch, as obtained in the method of the invention, will also be included in the label.

Moreover, when light reflection/scattering is measured there is no risk of damaging the sample and thereby record false measurements. When a notch is applied to a single crystal ingot produced according to the method of the invention, as an example of a longitudinal marking, the depth of the notch will typically have a predetermined value, e.g. 1.25 mm, which can be prepared according to the invention with a tolerance of ±0.15 mm. The predetermined value of the depth may be indicated as a surface characteristic parameter in the label for the single crystal ingot, and the actual depth of the notch, as obtained in the method of the invention, will also be included in the label.

The method of the invention may also obtain the sidewall angle of V-notches and the radius of curvature of U-notches. In the prior art methods these surface characteristic parameters can typically only be recorded at the end of a single crystal ingot where the notch, and thereby its cross-section is exposed. In contrast, the method of the invention allows that these surface characteristic parameters are obtained at several locations along the single crystal ingot. The angle between the sidewalls is commonly recorded in prior art methods with an uncertainty in the order of 1°. The radius of curvature is commonly recorded in prior art methods with an uncertainty in the order of 0.1 mm. With a laser scanner in the method of the invention, the angle between the sidewalls may be measured with an uncertainty down to 0.1°. Likewise, the measuring uncertainty of the radius of curvature is down to 0.005 mm when using a laser scanner in the method of the invention. For both the angle between the sidewalls and the radius of curvature the measurements can be performed at all positions of the ingot. When a single crystal ingot produced according to the invention is marked with a V-notch, the angle between the sidewalls will typically have predetermined value. For example, the predetermined value of a sidewall angle may be 90° which can be prepared according to the invention with a tolerance between +5° and -1°. When a single crystal ingot produced according to the invention is marked with a U-notch, the radius of curvature will have a predetermined value. For example, the predetermined value of the radius of curvature may 1.50 mm, which can be provided with a tolerance of 0.05 mm.

The method of the invention also provides improved measurements of flats as longitudinal markings on a single crystal ingot. When light reflection/scattering is used in the method, e.g. a laser scanner, the measuring uncertainty is typically down to 0.01 mm, compared to 0.1 mm for a slide caliper or a ruler used in the prior art. Furthermore, uncertainties caused by the determination of the correct measurement location of the width of a flat by eye, as required in the prior art methods, are avoided in the method of the invention, since determination by eye is not necessary. A flat will have a predetermined value for a single crystal ingot prepared in the method of the invention. For example, a major flat may have a width of 52.5 mm with a tolerance of 2.5 mm.

The use of a digital protractor to record the angle between longitudinal markings according to methods of the prior art typically cannot provide a measuring uncertainty below 0.5°. By calculating the angle between longitudinal markings from the data array in the method of the invention, the uncertainty can be down to 0.05°. When a single crystal ingot having two or more longitudinal markings is produced in the method of the invention, the angle between the longitudinal markings will have predetermined value. Typical values of the angle are 45° and 90°, but regardless of the actual angle the method of the invention allows positioning of the longitudinal markings within a tolerance of ±2.5°.

The method of obtaining a surface characteristic parameter of a longitudinal marking of a single crystal ingot can thus provide surface characteristic parameters obtained with a 10-fold improvement in the uncertainty compared to obtaining surface characteristic parameters using methods of the prior art.

The label included for a single crystal ingot prepared in the method of the invention may include the predetermined values of the longitudinal marking as well as the obtained surface characteristic parameters, e.g. the width, depth and other surface characteristic parameters of notches, the width of flats, and the obtained value and the corresponding tolerances.

Silicon single crystals ingots can be fabricated using different methods, such as the Czochralski process or the float-zone method. Single crystal ingots usually have a length from 50 cm to 200 cm and a weight ranging from a few kg to several hundred kg (such 100 kg, 200 kg, 300 kg) depending on crystal diameter and fabrication methods. Typical crystal diameters are 2 inch, 3 inch, 4 inch, 5 inch, 6 inch (150 mm), 8 inch (200 mm), 12 inch (300 mm) or 18 inch (450 mm). The grown crystal is typically a few mm larger than the target diameter, as the crystals are ground in later processing steps. Single crystal ingots from other materials than silicon (such as GaAs, InAs, InP), can be fabricated using similar processing methods. The method of preparing a silicon single crystal ingot of the invention may also comprise the step of slicing a wafer from the silicon single crystal ingot. A wafer sliced from a silicon single crystal ingot prepared according to the invention is within the scope.

The large single crystal ingot is cut into smaller single crystal ingots with a typical length in the range 1 cm to 80 cm, e.g. 10 cm to 60 cm.

The single crystal ingot is now ground to have a smooth and uniform surface. After grinding a longitudinal orientation marking can be carved into the single crystal ingot to mark the crystal orientation. The orientation of the marking is important for the further processing steps. The mark is typically a flat or a notch. One or more marks can be carved into the crystal. With two flats, one is typically larger than the other, and they are referred to as 'major flat' and 'minor flat'. The marks can also consist of both flats and notches. The marks can also be used for improved alignment at subsequent processing steps.

The flat width depends on the crystal diameter. For a 6 inch single crystal ingot the typical width of flat is in the range 10 mm to 70 mm. With more than one flat defined in the ingot, one is typically in the upper range, such as between 50 mm and 60 mm, and the other flat is in the other lower range, such as between 20 mm and 30 mm. For larger and smaller ingot diameters the size of the orientation flats scales correspondingly.

With two or more longitudinal markings, the subsequent longitudinal markings are typically positioned with respect to the first longitudinal marking. As an example a minor flat can be positioned such as 45°, 90°, or 180° with respect to a major flat. As an example two notches can be positioned 45°, 90°, or 180° with respect to each other. As an example, one or more notches can be positioned 45°, 90°, or 180° with respect to a flat.

The ingot with marks can now be cut into a plurality of wafers, thin single crystal discs, typically with a thickness in the range 300 μm to 1000 μm. The longitudinal markings carved in the ingot will also be present at the individual wafers. Thus, the geometric shape of the marks on the ingot is critical for the geometric shape of the marks on the wafers. However, the longitudinal markings are not necessarily identical, as the wafers are ground and polished after they are cut from the single crystal ingot.

The position of a longitudinal marking relative to the crystal orientation of a single crystal ingot will generally be expressed as an angle. In a specific embodiment, the single crystal ingot, especially a silicon single crystal ingot, will have two longitudinal markings, where a first orientation marking indicates the crystal orientation of the single crystal ingot, and a second longitudinal marking indicates the specific type of single crystal ingot, e.g. the doping type of a silicon single crystal ingot. When a single crystal ingot thus contains two longitudinal markings both may be flats, both may be notches, or the longitudinal markings both may be a flat and a notch. The first orientation marking will indicate the crystal orientation, e.g. {100}, {110} or {111}, and will be placed relative to the crystal orientation, and the second longitudinal marking will be placed relative to the first orientation marking.

The method of obtaining a surface characteristic parameter may comprise the step of determining a crystal orientation of the single crystal ingot, and the method of producing an orientation marked single crystal ingot does comprise the step of determining a crystal orientation of the single crystal ingot. Any method may be employed to determine the crystal orientation. The crystal orientation is preferably determined using X-ray crystallography, e.g. with an X-ray goniometer. X-ray crystallography is well-known to the skilled person.

Determining the crystal orientation is especially relevant for silicon single crystal ingots. When the surface characteristic parameter is obtained for a single crystal ingot having a longitudinal orientation marking in the surface of the single crystal ingot, the information provided from the determination is included in the data array. Thereby, the data array will contain information about the determined crystal orientation in addition to information about the longitudinal orientation marking thus providing a surface characteristic parameter of higher value to the end-user of the single crystal ingot since the single crystal has improved tolerances compared to a single crystal ingot that has not been analysed accordingly. The same observations are true for other longitudinal markings in the surface of the single crystal ingot having the longitudinal orientation marking. Due to the improved tolerances the final product, i.e. the final product produced from the single crystal ingot, of the end-user will have a lower rejection rate. A lowered rejection rate is especially relevant for silicon single crystal ingots of large diameter since the price of silicon single crystal ingots increases with increased diameter. For example, using X-ray crystallography in the method of the invention with FZ silicon single crystal ingots of diameters of 150 mm or more or 200 mm or more, and CZ silicon single crystal ingots with diameters of 300 mm or more is especially valuable. In an embodiment of the invention the single crystal ingot is a FZ silicon single crystal ingot having a diameter of 150 mm or more, e.g. 200 mm. In another embodiment of the invention the single crystal ingot is a CZ silicon single crystal ingots having a diameter of 300 mm or more.

Determination of the crystal orientation is used in the method of producing an orientation marked single crystal ingot of the invention. The crystal orientation is determined prior to the application of the longitudinal orientation marking based on the crystal orientation, although a subsequent analysis of the crystal orientation may also be included in the method. The combination of determining the crystal orientation, applying the orientation marking and obtaining the surface characteristic parameter provides an optimal single crystal ingot for the end-user of the single crystal ingot, since the single crystal ingot can be fitted with an orientation marking according to the specific needs of the end-user, e.g. with respect to specific details about a notch, e.g. the depth and width, and for a U-notch also the radius and roundness, and for a V-notch the angle between sidewalls, and when two or more longitudinal markings are desired also the notch-to-notch angle, parallelity notches-to-major flat, major flat-to-notch angle, flat-to-flat angle, etc. The same quality of a single crystal ingot cannot be achieved by determining the crystal orientation and applying the longitudinal marking without obtaining the surface characteristic parameter according to the invention, e.g. if the longitudinal marking is described using methods of the prior art. The method of the invention advantageously allows measurement of more than one longitudinal markings for the same single crystal ingot. Since two or more longitudinal markings can thus be measured simultaneously, the information about the longitudinal markings will be in the same data array, and improved data relating to the relative positioning of the two or more longitudinal markings, e.g. the angle between them, will be obtained.

FZ silicon single crystal ingots of diameters of 150 mm or more, e.g. 200 mm, or more and CZ silicon single crystal ingots with diameters of 300 mm or more are especially relevant for the production method of the invention, due to the higher value of such single crystal ingots compared to silicon single crystal ingots of smaller diameters, and due to the fact that the tolerances are improved even further compared to silicon single crystal ingots not produced according to the method. Thus, in an embodiment, the method produces a FZ silicon single crystal ingot having a diameter of 150 mm or more, e.g. 200 mm. In another embodiment the method produces a CZ silicon single crystal ingot having a diameter of 300 mm or more.

The orientation marked single crystal ingot produced according to the invention is labelled with the surface characteristic parameter. A single crystal ingot analysed, but not produced, according to the invention may also be labelled with the surface characteristic parameter obtained in the method of the invention. The labelling ensures that the information about the crystal orientation of a specific single crystal ingot is linked to the orientation marking so that the certification is improved. The labelling may be done as desired, and it may take the form of a physical label, e.g. on the single crystal itself, on a package containing the single crystal ingot, a sticker attached to the single crystal itself or to the package containing the single crystal ingot. Each wafer sliced from a silicon single crystal ingot may likewise be labelled, or groups of wafers cut from the same single crystal ingot may be labelled. The label may contain the actual information of the surface characteristic parameter, or the information of the surface characteristic parameter may be stored digitally or electronically in the label. Thus for example, the single crystal ingot may have a label with a unique identification number. The unique identification number may further link, e.g. hyperlink, to a database where the information is stored.

## Brief description of the figures

In the following the invention will be explained in greater detail with the aid of an example and with reference to the schematic drawings, in which

Figure 1 shows a schematic drawing of a single crystal ingot having a longitudinal marking;
Figure 2 shows examples of shapes of longitudinal markings;
Figure 3 shows examples of locations notches and flats in single crystal ingots;
Figure 4 shows an ingot scanner system of the invention;
Figure 5 shows a single crystal ingot mounted in an ingot scanner system of the invention;
Figure 6 shows the difference between scans at different offset values;
Figure 7 shows experimental data of a round notch obtained in the method of the invention;
Figure 8 shows experimental data obtained in the method of the invention from an ingot with two notches and two flats plotted in a polar coordinate system;
Figure 9 shows experimental data obtained in the method of the invention from an ingot with two notches and two flats plotted in a Cartesian coordinate system.

It should be understood that combinations of the features in the various embodiments and aspects are also contemplated, and that the various features, details and embodiments may be combined into other embodiments. In particular, it is contemplated that all definitions, features, details, and embodiments regarding the methods and the ingot scanner system described above apply equally to one another.

Reference to the figures serves to explain the invention and should not be construed as limiting the features to the specific embodiments as depicted.

**Detailed description of the invention**

The present invention relates to a method of obtaining a surface characteristic parameter of a longitudinal marking 11 of a single crystal ingot 10, a method of producing an orientation marked single crystal ingot 10, and to an ingot scanner system 20 for performing the method. The methods comprise rotating a single crystal ingot 10 around a rotational axis 23, recording distances from a measuring point 24 to the surface 14 of the single crystal ingot 10 at the angular positions, comparing the distances with the background shape to identify distances deviating from a background shape, and registering the angular position of distances deviating from the background shape and the corresponding distances. The surface characteristic parameter is defined from consecutive angular positions having distances deviating from the background shape and the corresponding distances. The method allows determination of the surface characteristic parameter at lower uncertainty.

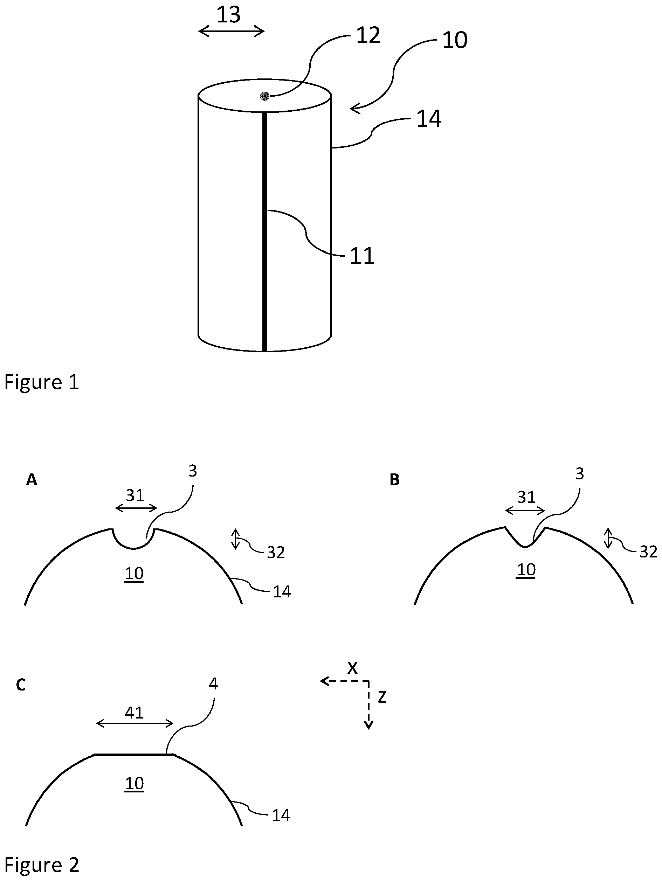

In the method of the first aspect a single crystal ingot 10 having a longitudinal marking 11 is analysed in order to obtain a surface characteristic parameter of the longitudinal marking 11. The single crystal ingot 10 is illustrated schematically in Figure 1. The single crystal ingot 10 is preferably a silicon single crystal ingot 10 and it may be produced in the float-zone (FZ) method or in the Czochralski (CZ) process. For example, a circular FZ silicon single crystal ingot 10 can have a diameter of 150 mm or 200 mm, and a circular CZ silicon single crystal ingot 10 can have a diameter of 300 mm. Both the FZ and the CZ methods are well-known to the skilled person who can readily obtain the silicon single crystal ingot 10. The circular silicon single crystal ingot 10 has a cylindrical shape with a longitudinal centre axis 12 and a radius 13 from the longitudinal centre axis 12. The radius 13 defines a surface 14 of the single crystal ingot 10.

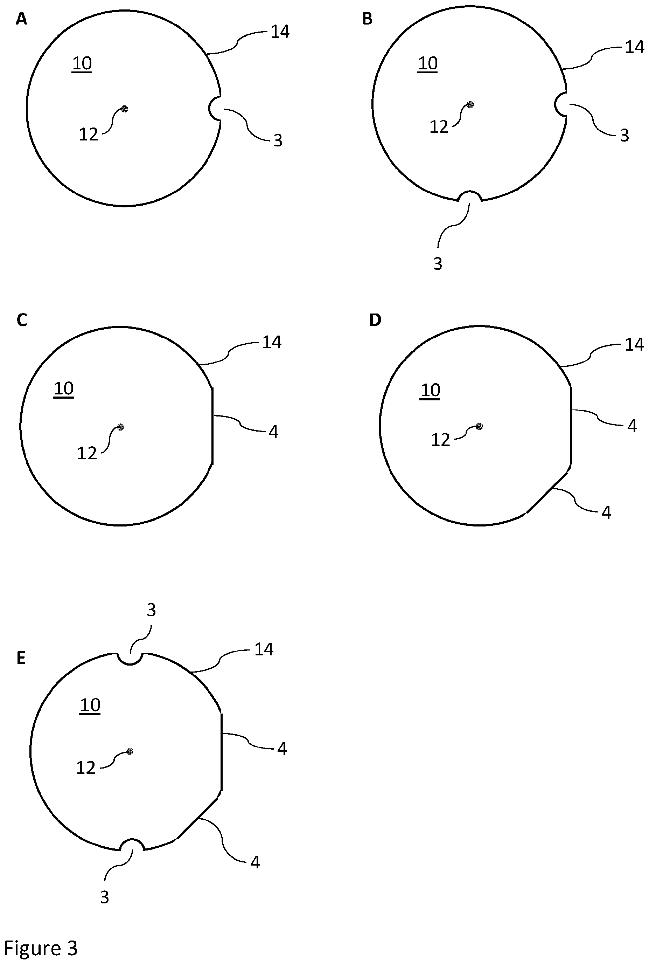

The longitudinal marking 11 is in the surface 14 of the single crystal ingot 10, e.g. the longitudinal marking 11 follows the full length of the single crystal ingot 10. The longitudinal marking 11 is typically carved into the surface 14 of the single crystal ingot 10. The longitudinal marking 11 may be a notch 3 or a flat 4. Exemplary notches 3 and flats 4 are shown in Figure 2 and in Figure 3. Thus, Figure 2 shows a U-notch in panel A and a V-notch in panel B, and panel C shows a flat. A notch will have a width 31 and a depth 32, and a flat 4 will have width 41. Figure 2 shows the X and the Z axes. Thus, the X axis in this instance corresponds to the width 31 of the notch 3 and to the width 41 of a flat 4, and the Z axis corresponds to the depth 32 of the notch 3. The Y axis (not shown) is the longitudinal axis of the single crystal ingot 10. Figure 3 shows single crystal ingot 10 having a single notch 3 in panel A, a single crystal ingot 10 having two notches 3 in panel B, a single crystal ingot 10 having a single flat 4 in panel C, a single crystal ingot 10 having two flats 4 in panel D, and a single crystal ingot 10 having two notches 3 and two flats 4 in panel E. When a single crystal ingot 10 has two or more longitudinal markings 11, the angle between the longitudinal markings 11 will be decided by the end-user of the single crystal ingot 10 but will typically follow a standard, e.g. the SEMI standard for silicon single crystal ingots 10.

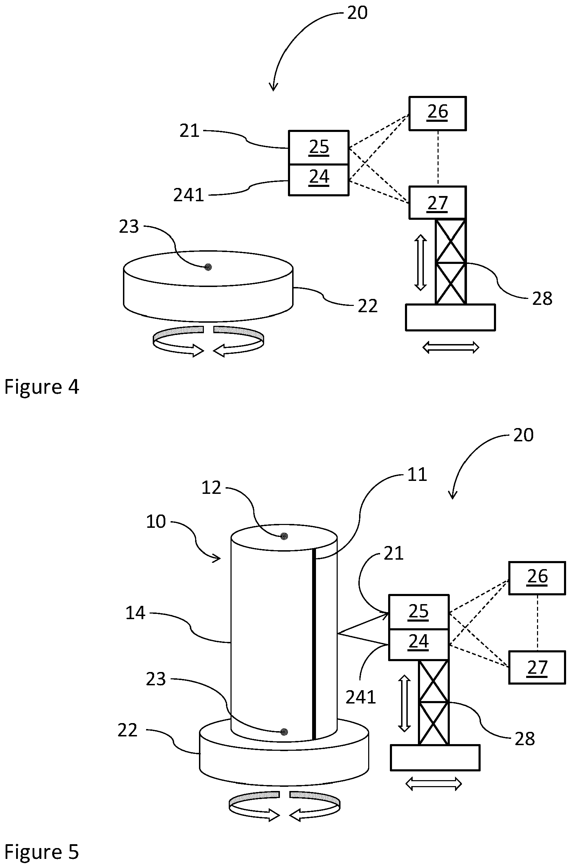

The single crystal ingot 10 is analysed in an ingot scanner system 2 of the invention. The ingot scanner system 2 is illustrated in Figure 4, and Figure 5 shows a single crystal ingot 10 mounted on a rotational device 22, e.g. a rotary stage, of the ingot scanner system 2. In Figure 4 and Figure 5 the rotation of the rotary stage 22 is indicated with arrows below the rotary stage 22. The ingot scanner system 2 is shown in Figure 4 and Figure 5 as having an elevating device 28. The elevating device 28 may lift and/or lower the optical line scanner 24,25 and/or move the optical line scanner 24,25 in a lateral direction; the possible movement is indicated with arrows.

The ingot scanner system 2 has a rotational device 22, which has a rotational axis 23, and the single crystal ingot 10 is around the rotational axis 23. The lateral distance between the rotational axis 23 and the longitudinal centre axis 12 of the single crystal ingot 10 corresponds to the offset value. The offset value should be as low as possible, and optimally the offset value is 0, i.e. the longitudinal centre axis 12 of the single crystal ingot 10 is aligned with the rotational axis 23 during analysis of the single crystal ingot 10.

The surface characteristic parameter is obtained by analysing the longitudinal marking 11. Specifically, the distance from a measuring point 21 located at a measuring distance from the rotational axis 23 to the surface 14 of the single crystal ingot 10 is recorded. The ingot scanner system 2 has a light source 24 at the emission point 241, which can emit a light toward the rotational axis 23. The ingot scanner system 20 has a light detector 25 at the measuring point 21, which is located at a measuring distance from the rotational axis 23. The light detector 25 registers light reflected and/or scattered from the surface 14 of the single crystal ingot 10 on the rotational device. The light source 24 and the light detector 25 may be combined in one unit, which is referred to as a "scanner". The scanner may particularly be a laser scanner, e.g. using a wavelength of 405 nm or 658 nm. The light source 24 and the light detector 25 may be referred to collectively as the "optical line profiler" 24,25.

Light registered by the light detector 25 may be stored in a data storage unit 26 as a data array containing the angular positions of the single crystal ingot 10 where the surface 14 has been analysed and light registered by the light detector 25 at the corresponding angular positions. The ingot scanner system 2 also has a data processing unit 27 for treating data in the data array. In Figure 4 and Figure 5 the possible data streams of the ingot scanner system 2 are shown as dotted lines. Thus, the data processing unit 27 can control either or both of the light source 24 and the light detector 25, and the light source 24 and/or the light detector 25 may send data to either or both of the data processing unit 27 and the data storage unit 26. The data processing unit 27 and the data storage unit 26 may also transmit data to and receive data from each other. The data storage unit 26 and the data processing unit 27 may be referred to collectively as the "measuring computational device" 26,27.

The ingot scanner system 20 is preferably configured to perform the method of the first aspect of the invention, and it can likewise also be used in the method of the second aspect of the invention.

The invention thus provides an ingot scanner system 20, e.g. a light detection system, for obtaining information on notches 3 and/or flats 4 on a single crystal ingot 10. In an embodiment, the ingot scanner system 20 comprises an optical line profiler 24,25, a rotary stage 22 and a measuring computing device 26,27. The optical line profiler 24,25 comprises a light emitter 24, focusing lenses, and a light detector 25, and is capable of measuring one or multiple points, such as 1280 data points, simultaneously.

In the method for obtaining data the single crystal ingot 10 is positioned on the rotary stage 22 within the measuring range of the optical line profiler 24,25. The single crystal ingot 10 is rotated while the optical line profiler 24,25 records profiles. The rotation of the single crystal ingot 10 may also be stopped for a high resolution analysis of a specific section, e.g. an angle corresponding to the location of a longitudinal marking 11. The data storage unit 26 stores the angular position and the corresponding distance obtained at that point; the distance may be a matrix, a line or a single point. The matrix, line or single point may collectively be referred to as a "profile" in the context of the invention. The single crystal ingot 10 is rotated over an angle, such as 360° for a full scan. For each angle, a value is retracted from the profiles obtained using the optical line profiler 24,25. The value can be the absolute distance from the measuring point 21 of the optical line profiler 24,25 to the single crystal ingot 10. These values, as a function of the angle retracted from the rotational device 22, can be graphically visualised using for example a Cartesian or polar coordinate system. The measuring computing device 26,72 is now used to fit the background shape and to find the offset value of the centre of rotation 23 compared to the longitudinal centre axis 12, e.g. the geometric centre, of the single crystal ingot 10. If the offset value is less than a given threshold value, such as 5 mm or less, such as less than 1 mm or less than 0.5 mm, the analysis is continued. The operator may be instructed to improve the centring of the single crystal ingot 10 to lower the offset value and repeat the measurement. For further analysis, the background is subtracted from the raw data to provide a data set with most values in the vicinity of zero, such is within the range -0.1 mm to 0.1 mm. Individual points failing this criterion can be regarded as outliers and removed from the data set or ignored. Groups of points below zero are interpreted as notches 3 and/or flats 4 depending on their size. The angular position of the centre of the notches 3 and/or centre of flats 4 is found from the data with the background removed.

In a subsequent step the notches 3 and/or flats 4 in the surface 14 of the single crystal ingot 10 are analysed at higher resolution. A preferred method for analysing a notch 3 is to rotate the single crystal ingot 10 to the position of the notch 3 as found in the previous step. A line scan is now obtained using the optical line profiler 24,25 for a high resolution profile, such as a profile consisting of 1280 data points spanning a 10 mm line segment. These data are analysed using the measuring computing device 26,27 to retrieve characteristics of the notch 3 shape, such as depth 32, width 31, radius of curvature, and roundness. One, two or more notches 3 can be analysed in sequence using the method of the invention. The width of an orientation flat 4 can be found from the angular scan with the background subtracted, for instance by thresholding the data, fitting a second order polynomial, and finding the intersection at z = 0.

The ingot scanner system includes an optical line profiler 24,25, including a light emitter 24 and a light detector 25, and a rotary stage 22. The optical line profiler 24,25 can be placed on one or more translational stages (not shown). The direction of the movement of the stages can be in a direction parallel to the longitudinal centre axis 12 of the single crystal ingot 10, or perpendicular to the surface of the single crystal ingot 10. In a preferred embodiment, one or more of the stages is motorised for automatic movement of the optical line profiler 24,25. A measuring computing device 26,27 is coupled to both the optical line profiler 24,25 and the rotary stage 22 for simultaneous acquisition of data.

Characterisation of notches 3 and flats 4 on single crystal ingots 10 is an important part of quality control. A single crystal ingot 10 is normally geometrical rotation invariant, but the crystalline structure has specific orientation, which might influence the fabrication and performance of devices made from it. To identify a specific crystalline orientation an X-ray goniometer can be used. Equipment capable of measuring the crystalline orientation and fabricating a flat 4 and/or notch 3 in the found position without human handling is available on the market.

The single crystal ingot 10 is positioned on the rotary stage 22. The longitudinal centre axis 12 of the cylindrical single crystal ingot 10 should overlay the rotational axis 23 of the rotary stage 22. The distance between these two axes is termed 'offset value'. Ideally the offset value should be exact zero. However, in practical conditions a small offset such as less than 2 mm, less than 1 mm, less than 0.5 mm, less than 0.3 mm, less than 0.2 mm, less than 0.1 mm can be acceptable. By way of example the offset value can be estimated by fitting a sinusoidal fit to the data using a least square regression algorithm. For a sinusoidal of the form

$$f(t) = A \cdot \sin(\omega t + \varphi) + B$$

The fitting parameter A, the amplitude of the sine, is equal to the offset between the two axes. The measuring computing device 26,27 can automatically check if A is smaller than a predefined threshold value, which is defined as the maximum allowable offset value. If A is larger than the threshold value, the measuring computing device 26,27 can stop the execution of the program, and tell the operator to improve the centring of the single crystal ingot 10. In a preferred embodiment the centring is performed automatically using a motorised stage (not shown).

In addition to the background fit several data processing steps might be involved. These steps include, but are not limited to, outlier removal, denoising, smoothing, filtering, thresholding and calibration adjustments.

An optical line scanner 24,25 comprises a light source 24, optical elements and a detector 25. For monochromatic light sources, these are also referred to as laser scanners. The light source 24 can be a monochromatic light source, such as a laser with a wavelength of 405 nm or 658 nm. The recorded data can consist of a single point, an average of points, or a line scan. A line scan is multiple individual points obtained in the vicinity of each other, such as with a distance of 1 $\mu$m, 5 $\mu$m, 10 $\mu$m, 20 $\mu$m, 50 $\mu$m, 100 $\mu$m, 200 $\mu$m, 500 $\mu$m, or 1000 $\mu$m. Multiple individual points refer to at least 3 points, at least 5 points, at least 10 points, at least 50 points. In a preferred embodiment 1280 data points are obtained in the line scan. The optical elements can include lenses, gratings, and mirrors. The detector device 25 can be a highly sensitive sensor matrix. By way of example an optical line scanner 24,25 based on laser line triangulation is used, which are suitable for two-dimensional profile detection on many difference surfaces, including the surface of a silicon single crystal ingot 10. Optical line scanners based on the laser triangulation principle are commercial available, such as the ScanControl series from MicroEpsilon. If the sample, e.g. the single crystal ingot 10, and optical line scanner 24,25 are moved relative to each other, e.g. if the single crystal ingot 10 is rotated, it is possible to obtain 3D measurement values.

Data from the optical line scanner 24,25 are transferred to a measuring computation device 26,27 using a cable or a wireless interface. Cable interfaces can include Ethernet or a RS422 protocol. Wireless interface can utilise a Wi-Fi protocol.

The single crystal ingot 10 is positioned on a rotational device 22. An encoder (not shown) is used for recording the actual position of the rotational device 22 and thereby the single crystal ingot 10. The single crystal ingot 10 is rotated incrementally over a predefined angle. As way of an example the predefined angle is 360°. The position of the rotary stage 22 is measured using an encoder. In a preferred embodiment the rotary stage 22 is rotated to an angle based on a priori knowledge of the position of the longitudinal markings. In a preferred embodiment the rotation is stopped when a predefined number of surface marks are reached. In a preferred embodiment the rotary stage 22 is set to continuous rotation while the optical line scanner 24,25 obtains data. This requires the data acquisition from the optical line scanner 24,25 to be fast relative to the angular rotation. As way of example a rotation speed of 6°/s and a profile acquisition frequency of more than 10 Hz for a 6 inch crystal are acceptable. Other rotation speeds such as 1°/s, 2°/s, 4°/s, 10°/s or 20°/s, 50°/s for a 6 inch crystal are found to be acceptable. For larger single crystal ingots 10 slower rotation speeds are preferable and for smaller single crystal ingots 10 faster rotation speeds are preferable. A higher profile acquisition frequency such as 20 Hz, 50 Hz, 100 Hz, 300 Hz, 1 kHz, 2 kHz or 5 kHz is preferable. Control and reading of the position of the rotational stage 22 is controlled with the measuring computational device 26,27. In a preferred embodiment, a high resolution stage with a resolution of less than 1 arcsec, less than 2 arcsec, less than 5 arcsec, less than 10 arcsec, less than 20 arcsec, less than 50 arcsec, is used. However, the rotational device 22 should be capable of handling the load of the single crystal ingots 10 with a typical weight of up to 20 kg, up to 30 kg, up to 40 kg, or up to 50 kg. High resolution rotational stages with high load capacities are commercial available, such as a 360° continuous rotation stage with stepper motor actuator model NR360S from Thorlabs, Inc.

At a given angle, the optical line scanner 24,25 is used to acquire one or more data points. The data are saved using a measuring computing device 26,27. The angular position of the rotary stage 22 is also saved. For visualisation one can display the data obtained with the optical line scanner 24,25 as a function of the angular position in a Cartesian or polar coordinate system.

The measuring procedure comprises a first step to centre the single crystal ingot 10 on the rotary stage 22. Mechanical equipment for assisting the operator in positioning the centre of the single crystal ingot 10 on the centre of the rotational stage 22 is used. In a preferred embodiment the positioning of the single crystal ingot 10 is assisted by using a plate with a hole matching the diameter of the single crystal ingot 10. As way of example, for a single crystal ingot 10 with a diameter of 150 mm, a plate with a hole of 150.5 mm can be used. In a preferred embodiment a mechanical centring device (not shown), such as a spring centre, is used to assist the alignment of the single crystal ingot 10 on the rotary stage 22.

The optical line scanner 24,25 is positioned at the point of interest relative to the single crystal ingot 10. As way of example, one can measure the single crystal ingot 10 at the middle of the single crystal ingot 10. As way of example, one can measure the single crystal ingots 10 near both ends, such as 5 mm, such as 20 mm from each end. As way of example, one can measure the single crystal ingots 10 at 5 positions or 10 positions distributed along its length. The vertical placement of the optical line scanner 24,25 can be performed either by an operator or automatically using an elevating device 28, e.g. a motorised stage. In a preferred embodiment an encoder is attached to vertical stage (not shown). The positioning can be made using a positioning arm, a robotic arm, a fixed setup, a manual translational stage. The position of the positioning device can be measured using an encoder. In a preferred embodiment a vertical motorised linear translational stage equipped with an encoder is used. Control and reading of the position of the elevating device 28 is controlled with a measuring computational device 26,27.

The optical line scanner 24,25 is now placed within its measuring range of the single crystal ingot 10. A horizontal linear translational stage is used for positioning the optical line scanner 24,25 in the direction normal to surface of the single crystal ingot 10. The optical line scanner 24,25 typically has a limited measuring range, such as a range between 50 mm and 300 mm, e.g. between 50 mm and 60 mm, or 70 mm to 120 mm, or 190 mm to 290 mm, from the light detector 25 to the single crystal ingot 10, i.e. the single crystal ingot 10. As way of example, the optical line scanner 24,25 has a measuring range from 48 mm to 58 mm, and the distance in the middle of the measuring range, in this case 53 mm, should be the target of the placement. However, in some cases it is beneficial to aim for a target near one of the ends of the range, to allow for more dynamic depth in one specific direction. The horizontal placement of the optical line scanner 24,25 can be performed either by an operator or automatically using elevating devices 28. A horizontal linear translational stage of the elevating device 28 is used to place the optical line scanner 24,25 a distance from the single crystal ingot 10, which is inside its measuring range. The positioning can be performed by hand by the operator based on predefined indicators. In a preferred embodiment, the horizontal linear translational stage is motorised. In a preferred embodiment, the position of the translational stage is recorded using encoders. Control of stage and readings of actual position is controlled with a measuring computational device.

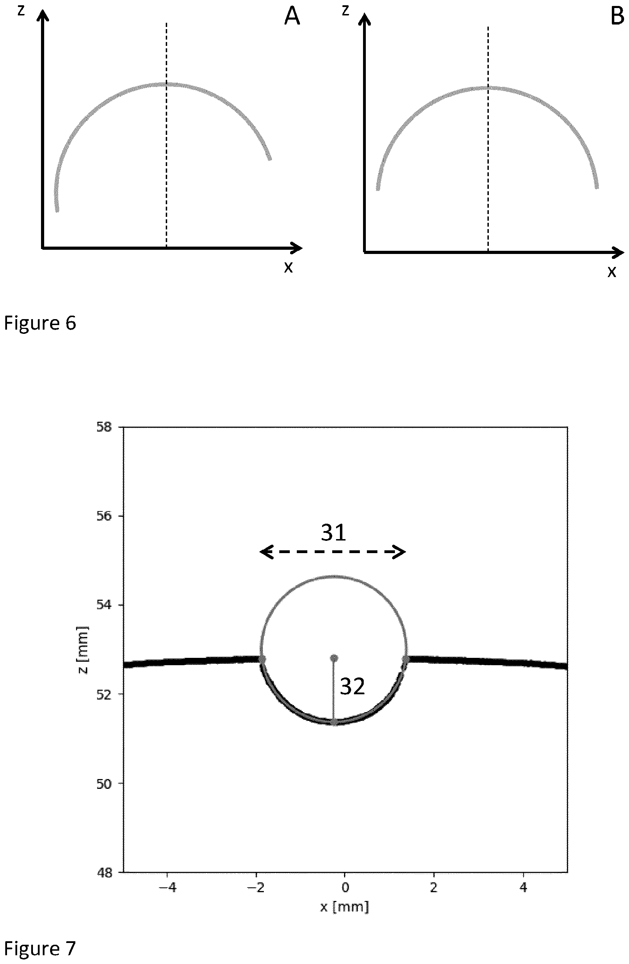

The centre of the measuring line of the optical line scanner 24,25 should be positioned at the centre of rotation 23. For measurements on the single crystal ingot 10, when the single crystal ingot 10 is perfectly centred on the rotational device, measurements with the optical line scanner 24,25 will show a symmetric curve when obtaining a line scan. If the optical line scanner 24,25 is off-centred, an asymmetric curve will be seen. An exemplary asymmetric curve is shown in panel A Figure 6, and the symmetric curve for the same single crystal ingot 10 is shown in panel B Figure 6. The asymmetry does not prevent measurements from being obtained, but the measuring uncertainty is higher when the optical line scanner 24,25 is offset. It is thus beneficial to the offset of the optical line scanner 24,25 as small as possible. Likewise, asymmetry does not prevent identification of the longitudinal marking 11. This positioning is independent of the size of the single crystal ingot 10, and it is therefore not necessary to adjust between measurements. Ideally, when first mounted and set up, no further adjustment is necessary. In a preferred embodiment, a translational stage is mounted under rotational stage 22 and/or the optical line scanner 24,25 to ease the alignment.

In a preferred embodiment two or more detectors 25 are used in the ingot scanner system 20 to improve measuring speed and/or the measuring capability. The detectors 25 can be placed on the same translational stages or on multiple independent stages.

The described fitting algorithms can all be performed on a normal desktop computer, a Raspberry Pi, or similar devices. The typical computational time to run the algorithms is less than 1 second. With multiprocessing, such as threading, data acquisition and analysis can be performed simultaneously. A measuring computing device 26,27 can, as way of example, be a personal desktop computer, a mini-computer, such as a Raspberry Pi 3 Model B+ from the Raspberry Pi foundation, a FPGA, or a similar device. In a preferred embodiment, more than one measuring computing device 26,27 is used for acquisition and/or analysis of the data.

In a preferred embodiment the vertical placement of the optical line scanner 24,25 is used to measure the length of the single crystal ingot 10 by finding the edge of the single crystal ingot 10 at both the top and the bottom. The length of the single crystal ingot 10 can be found as the difference between the readings of the upper and lower edge.

In the next step the data set of line scans, or single data points or average of data points, and corresponding angular positions are analysed using a digital processor 27. In a preferred embodiment the diameter of the single crystal ingot 10 is measured from the data set by finding the average distance from the single crystal ingot 10 to optical line scanner 24,25. This step requires the distance of the optical line scanner 24,25 to the centre of rotation of the rotary stage 22 to be known.

The background fit is now subtracted from the experimental data. In a preferred embodiment the background fit and removal algorithm is performed more than once to improve the fitting parameters. In a preferred embodiment the data are corrected for geometric distortions due to the off-centring of the single crystal ingot 10.

This new dataset is used for finding the position of the surface marks in the single crystal ingot 10. By way of example a peak finding algorithm is used for detection of the positions. More than one computation can be applied to improve the found position of the marks. The position of the surface characteristics is saved.

The flats 4 and/or notches 3 of the single crystal ingots 10 are now identified. By way of example, the depth of the peaks found in the previous step is used for the identification. The largest longitudinal marking is labelled as the major flat 4. From a priori knowledge the other longitudinal markings can be identified with respect to the major flat 4. In a preferred embodiment the longitudinal markings are identified without a priori knowledge of the positions by using other characteristics, such as width, to distinguish between major flat, minor flat and notches.

The width of the orientation flats 4 is calculated from the data set. By way of example, the flat 4 is selected by thresholding the data, and a polynomial of second order is fitted to the selected data. As the background is subtracted, the width of the flat 4 is found as the intersection of the polynomial with z = 0. The measurements of the width may be further improved by applying additional processing steps. These steps can include linear regression fit near the end of the flats and/or shape analysis of the curve. With more than one flat, the procedure is followed for each flat individually.

In the next step the crystal is rotated to a specific position based on the positions found in the previous step. By way of example, if the angular position of a notch 3 is measured to $\theta_{notch}$, the rotary stage 22 is moved to the angle $\theta_{notch}$. A line scan is now acquired at this position for detailed analysis of the specific mark. For a large mark, such as major flat 4, multiple points can be obtained. This can by way of example be the two ends of a flat 4.

In a preferred embodiment line scans obtained from the first rotation is used for a second analysis. Instead of rotating the single crystal ingot 10 to a given position, the data processing unit 27 is used to withdraw the previously obtained data for the position nearest the specific position. This is beneficial to reduce overall time for data acquisition. However, the accuracy of the data obtained by moving to a specific position instead of using pre-acquired data will be better or equal.

In a preferred embodiment the longitudinal markings 11 in the surface 14 are measured at multiple points by moving the vertical stage. With multiple points variation in the length of the single crystal ingot 10 can be detected. By way of example the single crystal ingots 10 are measured near both ends.

In a preferred embodiment the ingot scanner system 20 is used to characterise the single crystal ingot 10 for scratches, fractures, or other imperfections in the surface. The vertical line scanner is moved a short distance, such as 10 $\mu$m, 20 $\mu$m, 30 $\mu$m, 50 $\mu$m, 100 $\mu$m, 200 $\mu$m, 500 $\mu$m, 1000 $\mu$m, and a line scan is acquired. This sequence is repeated over a section of the single crystal ingot 10, extending up to the length of the single crystal ingot 10. In a preferred embodiment, the vertical stage is moving while the optical line scanner 24,25 acquires data. By way of example a notch 3 is scanned with a speed of 1 mm/s in the single crystal ingot 10 length direction starting from the bottom of the single crystal ingot 10 to the upper end of the single crystal ingot 10. Line scans are acquired for every 50 $\mu$m movement of the vertical stage. Each line scan is now analysed for imperfections with respect to a reference profile. Flats 4 or part of flats 4, such as a flat edge, can be characterised and analysed using a similar approach.

The analysis of a notch 3 is performed by comparing the circumference of the single crystal ingot 10 to the data points not considered as part of the notch, i.e. the background shape. By way of example, data points including the notch 3 are filtered using thresholding and/or a priori knowledge, and a circle, i.e. for a circular single crystal ingot 10, is fitted to the remaining data using a least mean square algorithm. The data points representing the notch 3 are now selected for geometrical analysis of the notch shape. By way of example, the notch data points are found by subtracting the circumference of the single crystal ingot 10, as described above, and thresholding the data.

The geometric shape of the notch 3 is found by analysis of the selected data points. By way of example, a circular shaped notch 3 is fitted by a circle fit using a least mean square algorithm. The radius of curvature is then equal to the radius of the fitted circle. The width of the notch 3 is found by finding the intersection to the circumference fit, and the height is found as the distance from the bottom of the notch 3 to edge of the crystal. Other notch 3 types, such as V-shaped notches 3, can be fitted by using another fit type, such as a second or higher order polynomial. In a preferred embodiment, two or more fits are used to extract the parameters. By way of example first order polynomials are used to find the intersections with the circumference fit, and a second order polynomial is used to find the bottom of the notch 3.

A 'roundness' parameter is defined to describe the uniformness of the notch 3. The roundness is defined as the difference between the right hand side and the left hand side of the notch 3. For a symmetrical notch 3 without any difference between the right hand side and the left hand side, the roundness is zero.

Other parameters describing the geometrical shape of a notch 3 may be defined and measured from the data. This includes, but is not limited to, the sidewall angle of V-notches 3, detection of wear of the grinding notch wheel, and roughness.

In a preferred embodiment, the circumference, i.e. the background shape, of the single crystal ingot 10 and the shape of the notch 3 are found at the same time by the fitting algorithm.

In a preferred embodiment, the ingot scanner system 20 measures the diameter of the single crystal ingot 10 from individual line scans. By way of example a circle is fitted to data sets without the presence of surface marks, and the radius of curvature of the fit, corresponds to the radius of the single crystal ingot 10. The precision can be increased by repeating such measurements on multiple points on the single crystal ingot 10. This method is beneficial compared to the diameter measurements using the absolute distance to the optical line scanner 24,25, as a reference point of the optical line scanner 24,25 is not necessary.

The parameters found for the geometric shape of the single crystal ingot 10 and surface characteristic parameters are saved to the data array, e.g. a database, text file, or similar. Also experimental data and processed data are saved for later reference. The data can be stored on a local storage device, a network storage device or a cloud storing. For easier organisation of data, they are stored in a database structure. The database references to other measurements performed on the same single crystal ingot 10. Graphical representation of the experimental data, processed data, and analysis results are also saved.

In a preferred embodiment the operator only has to position the single crystal ingot 10 and start the measuring sequence. Data acquisition and analysis is then handled automatically by the measuring computing device.

## Examples

### Example 1

A silicon single crystal ingot 10 having a notch 3 was analysed in the method of the invention. The acquired data showing a high resolution scan of a section of the surface 14 with a notch as a Cartesian plot is illustrated in Figure 7. The data are obtained using the line scan function of the optical measuring device, and thus consist of 1280 data points. Individual outliers have been removed from the data set. The plot in Figure 7 indicates the curved surface of the silicon single crystal ingot 10, and the notch 3 is shown. The width 31 and the depth 32 of the notch 3 obtained for the notch 3 were: Width 31: 3.24 mm, depth 32: 1.44 mm, radius: 1.63 mm, and roundness: 60 $\mu$m.

### Example 2

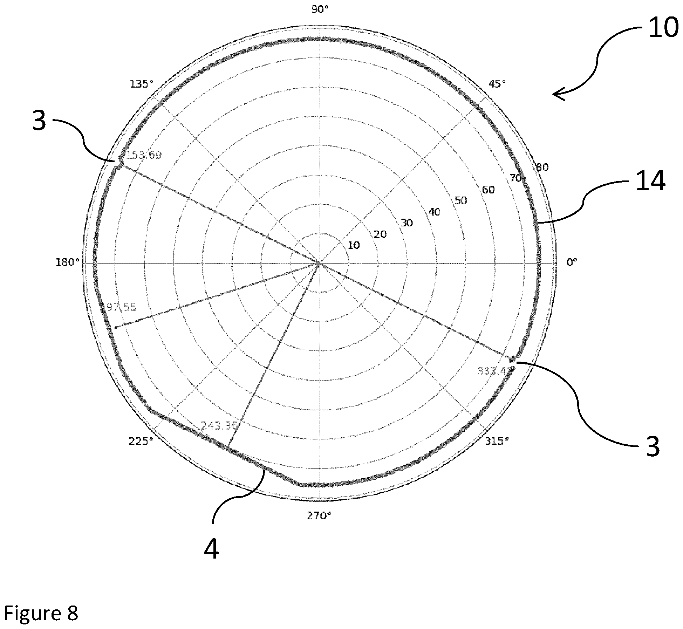

A 150 mm diameter silicon single crystal ingot 10 having two notches 3 and two flats 4 was prepared and analysed in the methods of the invention using a low resolution scan with 750 data points. The cross-section of the analysed silicon single crystal ingot 10 is shown in Figure 8 where it is overlaid on a polar plot. The plot shows the angles between orientation markings 11 as calculated from the analysis. As part of the analysis the surface marks are identified as major flat, minor flat, notch 1, and notch 2.

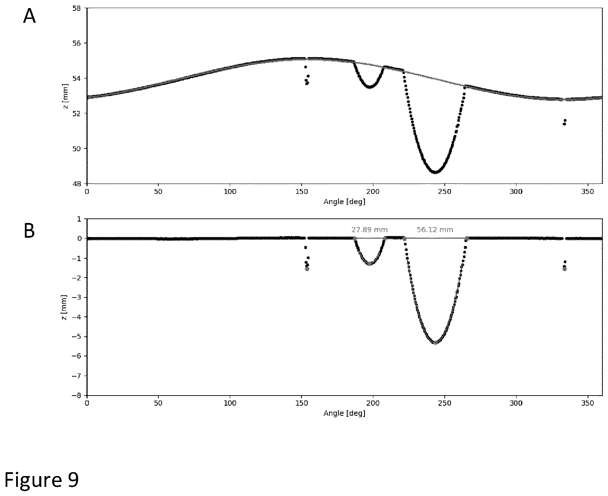

The analysis is shown as a Cartesian plot in Figure 9. Panel A shows the plot obtained before removing the background of the silicon single crystal ingot 10. The data in Panel A shows that the offset value was 1.1 mm. After removing the background of the silicon single crystal ingot 10, Panel B shows that the offset value was insignificant after the relocation of the silicon single crystal ingot 10 (the curve is "flat"). The angular positions of the flats 4 and notches 3 are found from the data. The angle between the minor and the major flats 4 can be calculated from the angular positions. The analysis indicated that the major flat 4 had a width of 56.12 mm and the minor flat 4 had a width of 27.89 mm. The resolution of this scan was not high enough to determine the surface description parameters of the notches 3, and a higher resolution scan, e.g. a scan at more than 750 points over the 360° of the single crystal ingot 10, can be used for this. Specifically, the notches 3 are shown at around 150° and 330°, so that the angle between the longitudinal markings can never the less be calculated and the position can be used to rotate the single crystal ingot 10 for the scanner to reanalyse the notches 3 at the higher resolution.

## Claims

1. A method of obtaining a surface characteristic parameter of a longitudinal orientation marking (11) of a single crystal ingot (10), such as a silicon single crystal ingot (10), the method comprising the steps of:

   - providing a single crystal ingot (10) having a cylindrical shape with a longitudinal centre axis (12) and a radius (13) from the longitudinal centre axis (12), the radius (13) defining a surface (14) of the single crystal ingot (10), the single crystal ingot (10) having a longitudinal orientation marking (11) carved into the surface (14) of the single crystal ingot (10), the longitudinal orientation marking (11) having a width (31, 41),
   - rotating the single crystal ingot (10) around a rotational axis (23), the rotational axis (23) being substantially parallel with the longitudinal centre axis (12) and located within an offset value from the longitudinal centre axis (12),
   - recording angular positions of the single crystal ingot (10),
   - recording distances from a measuring point (21) located at a measuring distance from the rotational axis (23) to the surface (14) of the single crystal ingot (10) at the angular positions,
   - providing a data array containing the angular positions and the distances at the corresponding angular positions,
   - calculating a background shape for the single crystal ingot (10) from the data array,
- comparing the distances with the background shape to identify distances deviating from the background shape,
- registering the angular position of distances deviating from the background shape and the corresponding distances, and
- simultaneously defining the surface characteristic parameter and the width (31, 41) from consecutive angular positions having distances deviating from the background shape and the corresponding distances.

2. The method of obtaining a surface characteristic parameter according to claim 1, wherein the single crystal ingot (10) has a substantially circular cross-section in the radial dimension.

3. A method of producing an orientation marked single crystal ingot (10), such as a silicon single crystal ingot (10), the method comprising the steps of:

- providing a single crystal ingot (10) having a cylindrical shape with a longitudinal centre axis (12) and a radius (13) from the longitudinal centre axis (12), the radius (13) defining a surface (14) of the single crystal ingot (10),
- determining a crystal orientation for the single crystal ingot (10),
- carving a longitudinal orientation marking (11) based on the crystal orientation into the surface (14) of the single crystal ingot (10) to provide an orientation marked single crystal, the longitudinal orientation marking (11) having a width (31, 41),
- obtaining a surface characteristic parameter of the orientation marked single crystal ingot (10) in the steps of:

- rotating the orientation marked single crystal ingot (10) around a rotational axis (23), the rotational axis (23) being substantially parallel with the longitudinal centre axis (12) and located within an offset value from the longitudinal centre axis (12),
- recording angular positions of the orientation marked single crystal ingot (10),
- recording distances from a measuring point (21) located at a measuring distance from the rotational axis (23) to the surface (14) of the orientation marked single crystal ingot (10) at the angular positions,
- providing a data array containing the angular positions and the distances at the corresponding angular positions,
- calculating a background shape for the orientation marked single crystal ingot (10) from the data array,

- comparing the distances with the background shape to identify distances deviating from the background shape,
- registering the angular position of distances deviating from the background shape and the corresponding distances, and
- simultaneously defining the surface characteristic parameter and the width (31, 41) from consecutive angular positions having distances deviating from the background shape and the corresponding distances,

- labelling the orientation marked single crystal ingot (10) with the surface characteristic parameter.

4. The method of producing an orientation marked single crystal ingot (10) according to claim 3 further comprising the step of grinding the surface (14) of the single crystal ingot (10) to provide the single crystal ingot (10) with a substantially circular cross-section in the radial dimension.

5. The method of obtaining a surface characteristic parameter according to any one of claims 1 or 2, or the method of producing an orientation marked single crystal ingot (10) according to any one of claims 3 or 4, wherein the method further comprises the step of moving the measuring point (21) in a longitudinal direction relative to the single crystal ingot (10).

6. The method of obtaining a surface characteristic parameter according to any one of claims 1, 2 or 5, or the method of producing an orientation marked single crystal ingot (10) according to any one of claims 3 to 5, wherein the offset value is 5 mm or less.

7. The method of obtaining a surface characteristic parameter according to any one of claims 1, 2, 5 or 6, or the method of producing an orientation marked single crystal ingot (10) according to any one of claims 3 to 6, further comprising determining the offset value.

8. The method of obtaining a surface characteristic parameter according to any one of claims 1, 2 or 5 to 7, or the method of producing an orientation marked single crystal ingot (10) according to any one of claims 3 to 7, further comprising the step of relocating the single crystal ingot (10) to minimise the offset value.

9. The method of obtaining a surface characteristic parameter according to any one of claims 1, 2 or 5 to 8, or the method of producing an orientation marked single crystal ingot (10) according to any one of claims 3 to 8, wherein the longitudinal orientation marking is a notch (30).

**10.** The method of obtaining a surface characteristic parameter according to any one of claims 1, 2 or 5 to 9, or the method of producing an orientation marked single crystal ingot (10) according to any one of claims 3 to 9, wherein the single crystal ingot (10) comprises two or more orientation markings (11).

**11.** The method of obtaining a surface characteristic parameter according to any one of claims 1, 2 or 5 to 10, or the method of producing an orientation marked single crystal ingot (10) according to any one of claims 3 to 9, wherein a light is emitted toward the rotational axis (23) and the distance is measured from light reflected and/or scattered from the surface (14) of the single crystal ingot (10).

**12.** The method of obtaining a surface characteristic parameter according to any one of claims 1, 2 or 5 to 11, or the method of producing an orientation marked single crystal ingot (10) according to any one of claims 3 to 11, wherein the background shape is calculated from distances recorded for angular positions spaced at angles in the range of 0.06° to 36° over a 360° rotation of the single crystal ingot (10).

**13.** The method of obtaining a surface characteristic parameter according to any one of claims 1, 2 or 5 to 12, or the method of producing an orientation marked single crystal ingot (10) according to any one of claims 3 to 12 further comprising the step of reanalysing the consecutive angular positions of the surface characteristic parameter at a higher resolution after identifying the consecutive angular positions.

**14.** The method of producing an orientation marked single crystal ingot (10) according to any one of claims 3 to 13 further comprising the step of slicing a wafer from the single crystal ingot (10).

**15.** An ingot scanner system (20) comprising:

- a rotational device (22) for rotating a single crystal ingot (10), the rotational device (22) having a rotational axis (23),
- a light source (24) for emitting a light toward the rotational axis (23), the light source (24) being located at a measuring distance from the rotational axis (23),
- a light detector (25) for registering light reflected and/or scattered from a surface (14) of a single crystal ingot (10) on the rotational device,
- a data storage unit (26) for storing a data array containing angular positions of the single crystal ingot (10) and light registered by the light detector (25) at the angular positions, and
- a data processing unit (27) configured to calculate distances from the measuring point (21) to the surface (14) of the single crystal ingot (10) from the data array, the data processing unit (27) further being configured to calculate a background shape for the single crystal ingot (10) from calculated distances and to identify distances deviating from the background shape,

wherein the ingot scanner system (20) is configured to obtain the surface characteristic parameter according to the method of any one of claims 1 to 13.

### Patentansprüche

**1.** Verfahren zum Gewinnen eines charakteristischen Oberflächenparameters einer Längsorientierungsmarkierung (11) eines Einkristall-Ingots (10), wie beispielsweise eines Silizium-Einkristall-Ingots (10), wobei das Verfahren die folgenden Schritte umfasst:

- Bereitstellen eines Einkristall-Ingots (10), der eine zylindrische Form mit einer Längsmittelachse (12) und einem Radius (13) von der Längsmittelachse (12) aufweist, wobei der Radius (13) eine Oberfläche (14) des Einkristall-Ingots (10) definiert und der Einkristall-Ingot (10) eine Längsorientierungsmarkierung (11) aufweist, die in die Oberfläche (14) des Einkristall-Ingots (10) eingeritzt ist, wobei die Längsorientierungsmarkierung (11) eine Breite (31, 41) aufweist,
- Drehen des Einkristall-Ingots (10) um eine Drehachse (23), wobei die Drehachse (23) zu der Längsmittelachse (12) im Wesentlichen parallel ist und innerhalb eines Versatzwertes von der Längsmittelachse (12) entfernt ist,
- Aufzeichnen von Winkelpositionen des Einkristall-Ingots (10),
- Aufzeichnen von Entfernungen von einem Messpunkt (21), der sich in einer Messentfernung von der Drehachse (23) befindet, zu der Oberfläche (14) des Einkristall-Ingots (10) an den Winkelpositionen,
- Bereitstellen eines Datenfelds, das die Winkelpositionen und die Entfernungen an den entsprechenden Winkelpositionen beinhaltet,
- Berechnen einer Hintergrundform für den Einkristall-Ingot (10) aus dem Datenfeld,
- Vergleichen der Entfernungen mit der Hintergrundform, um Entfernungen zu identifizieren, die von der Hintergrundform abweichen,
- Registrieren der Winkelposition von Entfernungen, die von der Hintergrundform abweichen, und der entsprechenden Entfernungen, und
- gleichzeitiges Definieren des charakteristischen Oberflächenparameters und der Breite (31, 41) aus aufeinanderfolgenden Winkelpositionen, die Entfernungen aufweisen, die von der Hintergrundform abweichen, und den entsprechenden Entfernungen.

2. Verfahren zum Gewinnen eines charakteristischen Oberflächenparameters nach Anspruch 1, wobei der Einkristall-Ingot (10) in der radialen Ausdehnung einen im Wesentlichen kreisförmigen Querschnitt aufweist.

3. Verfahren zum Erzeugen eines orientierungsmarkierten Einkristall-Ingots (10), wie beispielsweise eines Silizium-Einkristall-Ingots (10), wobei das Verfahren die folgenden Schritte umfasst:

    - Bereitstellen eines Einkristall-Ingots (10), der eine zylindrische Form mit einer Längsmittelachse (12) und einem Radius (13) von der Längsmittelachse (12) aufweist, wobei der Radius (13) eine Oberfläche (14) des Einkristall-Ingots (10) definiert,
    - Bestimmen einer Kristallorientierung für den Einkristall-Ingot (10),
    - Einritzen einer Längsorientierungsmarkierung (11) basierend auf der Kristallorientierung in die Oberfläche (14) des Einkristall-Ingots (10), um einen orientierungsmarkierten Einkristall-Ingot bereitzustellen, wobei die Längsorientierungsmarkierung (11) eine Breite (31, 41) aufweist,
    - Gewinnen eines charakteristischen Oberflächenparameters des orientierungsmarkierten Einkristall-Ingots (10) in den folgenden Schritten:

        - Drehen des orientierungsmarkierten Einkristall-Ingots (10) um eine Drehachse (23), wobei die Drehachse (23) zu der Längsmittelachse (12) im Wesentlichen parallel ist und sich innerhalb eines Versatzwertes von der Längsmittelachse (12) befindet,
        - Aufzeichnen von Winkelpositionen des orientierungsmarkierten Einkristall-Ingots (10),
        - Aufzeichnen von Entfernungen von einem Messpunkt (21), der sich in einer Messentfernung von der Drehachse (23) befindet, zu der Oberfläche (14) des orientierungsmarkierten Einkristall-Ingots (10) an den Winkelpositionen,
        - Bereitstellen eines Datenfelds, das die Winkelpositionen und die Entfernungen an den entsprechenden Winkelpositionen beinhaltet,
        - Berechnen einer Hintergrundform für den orientierungsmarkierten Einkristall-Ingot (10) aus dem Datenfeld,
        - Vergleichen der Entfernungen mit der Hintergrundform, um Entfernungen zu identifizieren, die von der Hintergrundform abweichen,

        - Registrieren der Winkelposition von Entfernungen, die von der Hintergrundform abweichen, und der entsprechenden Entfernungen, und
        - gleichzeitiges Definieren des charakteristischen Oberflächenparameters und der Breite (31, 41) aus aufeinanderfolgenden Winkelpositionen, die Entfernungen aufweisen, die von der Hintergrundform abweichen, und den entsprechenden Entfernungen,
        - Etikettieren des orientierungsmarkierten Einkristall-Ingots (10) mit dem charakteristischen Oberflächenparameter.

4. Verfahren zum Erzeugen eines orientierungsmarkierten Einkristall-Ingots (10) nach Anspruch 3, das ferner den Schritt des Schleifens der Oberfläche (14) des Einkristall-Ingots (10) umfasst, um den Einkristall-Ingot in der radialen Ausdehnung (10) mit einem im Wesentlichen kreisförmigen Querschnitt zu versehen.

5. Verfahren zum Gewinnen eines charakteristischen Oberflächenparameters nach einem der Ansprüche 1 oder 2 oder Verfahren zum Erzeugen eines orientierungsmarkierten Einkristall-Ingots (10) nach einem der Ansprüche 3 oder 4, wobei das Verfahren ferner den Schritt des Bewegens des Messpunkts (21) in einer Längsrichtung relativ zu dem Einkristall-Ingot (10) umfasst.

6. Verfahren zum Gewinnen eines charakteristischen Oberflächenparameters nach einem der Ansprüche 1, 2 oder 5 oder Verfahren zum Erzeugen eines orientierungsmarkierten Einkristall-Ingots (10) nach einem der Ansprüche 3 bis 5, wobei das Versatzwert 5 mm oder weniger ist.

7. Verfahren zum Gewinnen eines charakteristischen Oberflächenparameters nach einem der Ansprüche 1, 2, 5 oder 6 oder Verfahren zum Erzeugen eines orientierungsmarkierten Einkristall-Ingots (10) nach einem der Ansprüche 3 bis 6, das ferner das Bestimmen des Versatzwertes umfasst.

8. Verfahren zum Gewinnen eines charakteristischen Oberflächenparameters nach einem der Ansprüche 1, 2 oder 5 bis 7 oder Verfahren zum Erzeugen eines orientierungsmarkierten Einkristall-Ingots (10) nach einem der Ansprüche 3 bis 7, das ferner den Schritt des Umsetzens des Einkristall-Ingots (10) umfasst, um den Versatzwert zu minimieren.

9. Verfahren zum Gewinnen eines charakteristischen Oberflächenparameters nach einem der Ansprüche 1, 2 oder 5 bis 8 oder Verfahren zum Erzeugen eines orientierungsmarkierten Einkristall-Ingots (10) nach einem der Ansprüche 3 bis 8, wobei die Längsorientierungsmarkierung eine Kerbe (30) ist.

10. Verfahren zum Gewinnen eines charakteristischen Oberflächenparameters nach einem der Ansprüche 1, 2 oder 5 bis 9 oder Verfahren zum Erzeugen eines orientierungsmarkierten Einkristall-Ingots (10) nach einem der Ansprüche 3 bis 9, wobei der Einkristall-Ingot (10) zwei oder mehr Orientierungsmarkierungen (11) umfasst.

11. Verfahren zum Gewinnen eines charakteristischen Oberflächenparameters nach einem der Ansprüche 1, 2 oder 5 bis 10 oder Verfahren zum Erzeugen eines orientierungsmarkierten Einkristall-Ingots (10) nach einem der Ansprüche 3 bis 9, wobei Licht in Richtung der Drehachse (23) emittiert wird und die Entfernung aus dem Licht, das von der Oberfläche (14) des Einkristall-Ingots (10) reflektiert und/oder gestreut wird, gemessen wird.

12. Verfahren zum Gewinnen eines charakteristischen Oberflächenparameters nach einem der Ansprüche 1, 2 oder 5 bis 11 oder Verfahren zum Erzeugen eines orientierungsmarkierten Einkristall-Ingots (10) nach einem der Ansprüche 3 bis 11, wobei die Hintergrundform aus Entfernungen berechnet wird, die für Winkelpositionen, die in Winkeln im Bereich von 0,06° bis 36° über eine 360°-Drehung des Einkristall-Ingots (10) beabstandet sind, aufgezeichnet werden.

13. Verfahren zum Gewinnen eines charakteristischen Oberflächenparameters nach einem der Ansprüche 1, 2 oder 5 bis 12 oder Verfahren zum Erzeugen eines orientierungsmarkierten Einkristall-Ingots (10) nach einem der Ansprüche 3 bis 12, das ferner den Schritt des erneuten Analysierens der aufeinanderfolgenden Winkelpositionen des charakteristischen Oberflächenparameters bei einer höheren Auflösung nach dem Identifizieren der aufeinanderfolgenden Winkelpositionen umfasst.

14. Verfahren zum Erzeugen eines orientierungsmarkierten Einkristall-Ingots (10) nach einem der Ansprüche 3 bis 13, das ferner den Schritt des Schneidens eines Wafers aus dem Einkristall-Ingot (10) umfasst.

15. Ingot-Scannersystem (20), das Folgendes umfasst:

- eine Drehvorrichtung (22) zum Drehen eines Einkristall-Ingots (10), wobei die Drehvorrichtung (22) eine Drehachse (23) aufweist.
- eine Lichtquelle (24) zum Emittieren von Licht zu der Drehachse (23), wobei sich die Lichtquelle (24) in einer Messentfernung von der Drehachse (23) befindet,

- einen Lichtdetektor (25) zum Registrieren von Licht, das von einer Oberfläche (14) eines Einkristall-Ingots (10) auf der Drehvorrichtung reflektiert und/oder gestreut wird,
- eine Datenspeichereinheit (26) zum Speichern eines Datenfeldes, das Winkelpositionen des Einkristall-Ingots (10) und Licht, das durch den Lichtdetektor (25) an den Winkelpositionen detektiert wird, beinhaltet, und
- eine Datenverarbeitungseinheit (27), die konfiguriert ist, Entfernungen von dem Messpunkt (21) zu der Oberfläche (14) des Einkristall-Ingots (10) aus dem Datenfeld zu berechnen, wobei die Datenverarbeitungseinheit (27) ferner konfiguriert ist, eine Hintergrundform für den Einkristall-Ingot (10) aus den berechneten Entfernungen zu berechnen und Entfernungen, die von der Hintergrundform abweichen, zu identifizieren,

wobei das Ingot-Scannersystem (20) konfiguriert ist, den charakteristischen Oberflächenparameter gemäß dem Verfahren nach einem der Ansprüche 1 bis 13 zu gewinnen.

**Revendications**

1. Procédé d'obtention d'un paramètre de caractéristique de surface d'un marquage d'orientation longitudinale (11) d'un lingot monocristallin (10), tel qu'un lingot monocristallin de silicium (10), le procédé comprenant les étapes de :

- fourniture d'un lingot monocristallin (10) ayant une forme cylindrique avec un axe central longitudinal (12) et un rayon (13) à partir de l'axe central longitudinal (12), le rayon (13) définissant une surface (14) du lingot monocristallin (10), le lingot monocristallin (10) ayant un marquage d'orientation longitudinale (11) gravé dans la surface (14) du lingot monocristallin (10), le marquage d'orientation longitudinale (11) ayant une largeur (31, 41),
- rotation du lingot monocristallin (10) autour d'un axe de rotation (23), l'axe de rotation (23) étant sensiblement parallèle à l'axe central longitudinal (12) et situé dans une valeur de décalage par rapport à l'axe central longitudinal (12),
- enregistrement de positions angulaires du lingot monocristallin (10),
- enregistrement de distances depuis un point de mesure (21) situé à une distance de mesure de l'axe de rotation (23) jusqu'à la surface (14) du lingot monocristallin (10) aux positions angulaires,
- fourniture d'un tableau de données contenant les positions angulaires et les distances aux positions angulaires correspondantes,

- calcul d'une forme d'arrière-plan pour le lingot monocristallin (10) à partir du tableau de données,

- la comparaison des distances avec la forme d'arrière-plan pour identifier les distances déviant de la forme d'arrière-plan,

- enregistrement de la position angulaire de distances déviant de la forme d'arrière-plan et des distances correspondantes, et

- définition simultanée du paramètre de caractéristique de surface et de la largeur (31, 41) à partir des positions angulaires consécutives ayant des distances déviant de la forme d'arrière-plan et des distances correspondantes.

**2.** Procédé d'obtention d'un paramètre de caractéristique de surface selon la revendication 1, le lingot monocristallin (10) ayant une section transversale sensiblement circulaire dans la dimension radiale.

**3.** Procédé de production d'un lingot monocristallin marqué par orientation (10), tel qu'un lingot monocristallin de silicium (10), le procédé comprenant les étapes suivantes :

- la fourniture d'un lingot monocristallin (10) ayant une forme cylindrique avec un axe central longitudinal (12) et un rayon (13) à partir de l'axe central longitudinal (12), le rayon (13) définissant une surface (14) du lingot monocristallin (10),

- la détermination d'une orientation cristalline pour le lingot monocristallin (10),

- la gravure d'un marquage d'orientation longitudinale (11) sur la base de l'orientation cristalline dans la surface (14) du lingot monocristallin (10) pour fournir un monocristal marqué par orientation, le marquage d'orientation longitudinale (11) ayant une largeur (31, 41),

- l'obtention d'un paramètre de caractéristique de surface du lingot monocristallin marqué par orientation (10) dans les étapes de :

- rotation du lingot monocristallin marqué par orientation (10) autour d'un axe de rotation (23), l'axe de rotation (23) étant sensiblement parallèle à l'axe central longitudinal (12) et situé dans une valeur de décalage par rapport à l'axe central longitudinal (12),

- enregistrement de positions angulaires du lingot monocristallin marqué par orientation (10),

- enregistrement de distances depuis un point de mesure (21) situé à une distance de mesure de l'axe de rotation (23) jusqu'à la surface (14) du lingot monocristallin marqué par orientation (10) aux positions angulaires,

- fourniture d'un tableau de données contenant les positions angulaires et les distances aux positions angulaires correspondantes,

- calcul d'une forme d'arrière-plan pour le lingot monocristallin marqué par orientation (10) à partir du tableau de données,

- la comparaison des distances avec la forme d'arrière-plan pour identifier les distances déviant de la forme d'arrière-plan,

- enregistrement de la position angulaire de distances déviant de la forme d'arrière-plan et des distances correspondantes, et

- définition simultanée du paramètre de caractéristique de surface et de la largeur (31, 41) à partir de positions angulaires consécutives ayant des distances déviant de la forme d'arrière-plan et des distances correspondantes,

- étiquetage du lingot monocristallin marqué par orientation (10) avec le paramètre de caractéristique de surface.

**4.** Procédé de production d'un lingot monocristallin marqué par orientation (10) selon la revendication 3, comprenant en outre l'étape de meulage de la surface (14) du lingot monocristallin (10) pour fournir au lingot monocristallin (10) une section transversale sensiblement circulaire dans la dimension radiale.

**5.** Procédé d'obtention d'un paramètre de caractéristique de surface selon l'une quelconque des revendications 1 ou 2, ou procédé de production d'un lingot monocristallin marqué par orientation (10) selon l'une quelconque des revendications 3 ou 4, le procédé comprenant en outre l'étape de déplacement du point de mesure (21) dans une direction longitudinale par rapport au lingot monocristallin (10).

**6.** Procédé d'obtention d'un paramètre de caractéristique de surface selon l'une quelconque des revendications 1, 2 ou 5, ou procédé de production d'un lingot monocristallin marqué par orientation (10) selon l'une quelconque des revendications 3 à 5, la valeur de décalage étant de 5 mm ou moins.

**7.** Procédé d'obtention d'un paramètre de caractéristique de surface selon l'une quelconque des revendications 1, 2, 5 ou 6, ou procédé de production d'un lingot monocristallin marqué par orientation (10) selon l'une quelconque des revendications 3 à 6, comprenant en outre la détermination de la valeur de décalage.

**8.** Procédé d'obtention d'un paramètre de caractéristique de surface selon l'une quelconque des revendications 1, 2 ou 5 à 7, ou procédé de production d'un lingot monocristallin marqué par orientation (10) selon l'une quelconque des revendications 3 à 7, comprenant en outre l'étape de repositionnement du lingot monocristallin (10) pour minimiser la valeur de décalage.

9. Procédé d'obtention d'un paramètre de caractéristique de surface selon l'une quelconque des revendications 1, 2 ou 5 à 8, ou procédé de production d'un lingot monocristallin marqué par orientation (10) selon l'une quelconque des revendications 3 à 8, le marquage d'orientation longitudinale étant une encoche (30).

10. Procédé d'obtention d'un paramètre de caractéristique de surface selon l'une quelconque des revendications 1, 2 ou 5 à 9, ou procédé de production d'un lingot monocristallin marqué par orientation (10) selon l'une quelconque des revendications 3 à 9, le lingot monocristallin (10) comprenant deux marquages d'orientation (11) ou plus.

11. Procédé d'obtention d'un paramètre de caractéristique de surface selon l'une quelconque des revendications 1, 2 ou 5 à 10, ou procédé de production d'un lingot monocristallin marqué par orientation (10) selon l'une quelconque des revendications 3 à 9, une lumière étant émise vers l'axe de rotation (23) et la distance étant mesurée à partir de la lumière réfléchie et/ou diffusée par la surface (14) du lingot monocristallin (10).

12. Procédé d'obtention d'un paramètre de caractéristique de surface selon l'une quelconque des revendications 1, 2 ou 5 à 11, ou procédé de production d'un lingot monocristallin marqué par orientation (10) selon l'une quelconque des revendications 3 à 11, la forme d'arrière-plan étant calculée à partir de distances enregistrées pour des positions angulaires espacées à des angles dans la plage de 0,06° à 36° sur une rotation de 360° du lingot monocristallin (10).

13. Procédé d'obtention d'un paramètre de caractéristique de surface selon l'une quelconque des revendications 1, 2 ou 5 à 12, ou procédé de production d'un lingot monocristallin marqué par orientation (10) selon l'une quelconque des revendications 3 à 12, comprenant en outre l'étape de réanalyse des positions angulaires consécutives du paramètre de caractéristique de surface à une résolution plus élevée après identification des positions angulaires consécutives.

14. Procédé de production d'un lingot monocristallin marqué par orientation (10) selon l'une quelconque des revendications 3 à 13, comprenant en outre l'étape de découpe d'une plaquette à partir du lingot monocristallin (10).

15. Système de balayage de lingot (20) comprenant :

  - un dispositif de rotation (22) pour entraîner en rotation un lingot monocristallin (10), le dispositif de rotation (22) ayant un axe de rotation (23),
  - une source de lumière (24) pour émettre une lumière vers l'axe de rotation (23), la source de lumière (24) étant située à une distance de mesure de l'axe de rotation (23),
  - un détecteur de lumière (25) pour enregistrer la lumière réfléchie et/ou diffusée par une surface (14) d'un lingot monocristallin (10) sur le dispositif de rotation,
  - une unité de stockage de données (26) pour stocker un tableau de données contenant des positions angulaires du lingot monocristallin (10) et la lumière enregistrée par le détecteur de lumière (25) aux positions angulaires, et
  - une unité de traitement de données (27) configurée pour calculer des distances depuis le point de mesure (21) jusqu'à la surface (14) du lingot monocristallin (10) à partir du tableau de données, l'unité de traitement de données (27) étant en outre configurée pour calculer une forme d'arrière-plan pour le lingot monocristallin (10) à partir de distances calculées et pour identifier les distances déviant de la forme d'arrière-plan,

le système de balayage de lingot (20) étant configuré pour obtenir le paramètre de caractéristique de surface conformément au procédé selon l'une quelconque des revendications 1 à 13.

Figure 1

Figure 2

Figure 3

Figure 4

Figure 5

Figure 6

Figure 7

Figure 8

Figure 9

**EP 3 908 686 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0610563 A
- US 2017052024 A
- CN 106323193